# EUROPEAN PATENT APPLICATION

(11) **EP 4 539 368 A1**
(43) Date of publication of application: **16.04.2025**
(21) Application number: 23826107.7
(22) Date of filing: 31.05.2023
(51) Int. Cl.: H04L 1/00, H03M 13/11

(54) **CODING METHOD AND APPARATUS, AND DECODING METHOD AND APPARATUS**

(30) Priority: 24.06.2022 CN 202210725659
(71) Applicant: Huawei Technologies Co., Ltd., Shenzhen, Guangdong 518129 (CN)
(72) Inventor: LIN, Wei, Shenzhen, Guangdong 518129 (CN); LI, Jiahui, Shenzhen, Guangdong 518129 (CN); MA, Mengyao, Shenzhen, Guangdong 518129 (CN); TANG, Zihan, Shenzhen, Guangdong 518129 (CN); GU, Jiaqi, Shenzhen, Guangdong 518129 (CN); YANG, Xun, Shenzhen, Guangdong 518129 (CN); DU, Yinggang, Shenzhen, Guangdong 518129 (CN)
(74) Representative: Gill Jennings & Every LLP
(86) International application number: PCT/CN2023/097621
(87) International publication number: WO 2023/246458

(57) **Abstract**

An encoding method, a decoding method, and an apparatus are provided. The methods include: A transmit end obtains a first bit sequence, performs LDPC encoding based on the first bit sequence to obtain a second bit sequence, and sends the second bit sequence. The first bit sequence includes K₀ information bits, sparsity of the first bit sequence is first sparsity, the second bit sequence includes K₁ information bits and N₁ parity bits, a value of K₁ is determined based on the first sparsity, K₁ is less than K₀, and K₁ is a nonnegative integer. Correspondingly, a receive end obtains the second bit sequence, and then performs LDPC decoding on the second bit sequence based on the first sparsity and a code rate, to obtain the K₀ information bits. The methods can effectively ensure decoding performance of the receive end.

## Description

This application claims priority to Chinese Patent Application No. 202210725659.8, filed with the China National Intellectual Property Administration on June 24, 2022 and entitled "ENCODING METHOD, DECODING METHOD, AND APPARATUS", which is incorporated herein by reference in its entirety.

### TECHNICAL FIELD

This application relates to the field of communication technologies, and in particular, to an encoding method, a decoding method, and an apparatus.

### BACKGROUND

With development of information technologies and progress of society, people have increasing requirements for information and put forward higher requirements for enjoying comprehensive services such as voice, data, image, and video services, and different types of multimedia services anytime and anywhere. Therefore, multimedia communication has become a focus of people's attention. A coding and transmission technology for raw data such as a wireless video also becomes a research focus in an existing multimedia communication field. Coding is mainly classified into source coding and channel coding. A main indicator of the source coding is coding efficiency. A main objective of the channel coding is to improve reliability of information transmission.

A communication system like a cellular network or Wi-Fi may use a separate source channel coding (separate source-channel coding, SSCC) scheme. In this scheme, the source coding is usually completed at an application layer, and the channel coding is usually completed at a physical layer. Conventional source coding (for example, compression of sources such as images, videos, voices, and texts) does not have an error tolerance capability. Therefore, through source-channel coding, channel coding may be performed at the physical layer in combination with a retransmission mechanism or the like, to enable a receive end to implement error-free recovery of bits transmitted at the physical layer. To further improve transmission performance, the communication system may alternatively use a joint source-channel coding (joint source-channel coding, JSCC) scheme. This scheme can implement both source compression and channel protection. For example, the JSCC scheme may be implemented based on a low-density parity-check (low-density parity-check, LDPC) code.

However, performance of the JSCC scheme can be further improved.

### SUMMARY

Embodiments of this application provide an encoding method, a decoding method, and an apparatus, to effectively improve decoding performance of a receive end.

According to a first aspect, an embodiment of this application provides an encoding method. The method is applied to a transmit end, and the method includes: obtaining a first bit sequence, where sparsity of the first bit sequence is first sparsity, the first sparsity is used to indicate a proportion of 1 or 0 in the first bit sequence, the first bit sequence includes K₀ information bits, and K₀ is a positive integer; performing LDPC encoding based on the first bit sequence to obtain a second bit sequence, where the second bit sequence includes K₁ information bits and N₁ parity bits, a value of K₁ is determined based on the first sparsity, K₁ is less than K₀, K₁ is a nonnegative integer, and N₁ is a positive integer; and sending the second bit sequence.

In this embodiment of this application, the transmit end may perform LDPC encoding based on sparsity of the K₀ information bits (namely, the first sparsity), to obtain the K₁ information bits and the N₁ parity bits, where K₁ is less than K₀. Without an increase in complexity of a system, transmission performance of the system in a scenario with a biased source is effectively improved, and decoding performance of a receive end can be effectively ensured, so that a decoding threshold of the receive end is low.

In a possible implementation, the performing LDPC encoding based on the first bit sequence to obtain a second bit sequence includes: if the first sparsity is less than or equal to a first threshold, performing LDPC encoding based on the first bit sequence to obtain the second bit sequence.

In this embodiment of this application, when the first sparsity is less than or equal to the first threshold, the transmit end performs LDPC encoding on the K₀ information bits to obtain the K₁ information bits. At a high signal-to-noise ratio (signal-to-noise ratio, SNR), a code rate greater than 1 can be obtained with excellent performance. For example, a higher code rate indicates a smaller quantity of transmitted bits, fewer occupied channel transmission resources, and higher transmission efficiency. In addition, decoding performance of the receive end is effectively ensured. Moreover, transmission performance at a medium or low SNR can also be improved.

In a possible implementation, the performing LDPC encoding based on the first bit sequence to obtain the second bit sequence includes: performing LDPC encoding based on the first bit sequence to obtain a third bit sequence, where the third bit sequence includes K₀ information bits and N₀ parity bits, and N₀ is an integer greater than or equal to N₁; and performing, based on the first sparsity, at least one of the following: determining the N₁ parity bits from the N₀ parity bits, and determining the K₁ information bits from the K₀ information bits.

In a possible implementation, the N₁ parity bits are determined based on A parity columns in a base graph (base graph, BG) 1, or the N₁ parity bits are determined based on B parity columns in a base graph BG2, both A and B are positive integers, A is less than 46, and B is less than 41.

In a possible implementation, the A parity columns are determined in order from left to right by using core parity columns in the BG1 as a start point, or the B parity columns are determined in order from left to right by using core parity columns in the BG2 as a start point.

In this embodiment of this application, the A parity columns or the B parity columns are determined in order from left to right by using the core parity columns as a start point. This can ensure that the receive end can correctly obtain the K₀ information bits through decoding based on the N₁ parity bits and the K₁ information bits, thereby ensuring decoding performance.

In a possible implementation, when the first sparsity is less than or equal to a second threshold, the A parity columns do not include a 1^{st} column of extension parity columns in the BG1, and the B parity columns include a 1^{st} column of extension parity columns in the BG2.

In this embodiment of this application, when the first sparsity is less than or equal to the second threshold, parity bits corresponding to the 1^{st} column of the extension parity columns in the BG1 are not transmitted, and parity bits corresponding to the 1^{st} column of the extension parity columns in the BG2 are transmitted. This can further improve decoding performance of the receive end.

In a possible implementation, when the first sparsity is greater than a second threshold, the A parity columns include a 1^{st} column of extension parity columns in the BG1, or the B parity columns include a 1^{st} column of extension parity columns in the BG2.

In a possible implementation, A is greater than or equal to 8.

In this embodiment of this application, parity bits obtained when A is greater than or equal to 8 can ensure decoding performance of the receive end on while occupying as few transmission resources as possible by the transmit end, and can still be used to effectively obtain the K₀ information bits through decoding.

In a possible implementation, B is greater than or equal to 5.

In this embodiment of this application, parity bits obtained when B is greater than or equal to 5 can ensure decoding performance of the receive end while occupying as few transmission resources as possible by the transmit end, and can still be used to effectively obtain the K₀ information bits through decoding.

In a possible implementation, the K₁ information bits are determined based on C information columns in the base graph BG1, or the K₁ information bits are determined based on D information columns in the base graph BG2, and both C and D are nonnegative integers.

In a possible implementation, the C information columns are determined in order from right to left by using the core parity columns in the BG1 as a start point, or the D information columns are determined in order from right to left by using the core parity columns in the BG2 as a start point.

In this embodiment of this application, C parity columns or D parity columns are determined in order from right to left by using the core parity columns as a start point. This can ensure that the receive end can correctly obtain the K₀ information bits through decoding based on the K₁ information bits and the N₁ parity bits, thereby ensuring decoding performance.

In a possible implementation, C is less than or equal to 20, or D is less than or equal to 8.

Generally, the BG1 may include 22 information columns, and the BG2 may include 10 information columns. In this embodiment of this application, the transmit end initially may perform encoding based on all information columns, but does not transmit all information bits; instead, the transmit end performs encoding based on the C information columns determined from the BG1 or the D information columns determined from the BG2 in order from right to left by using the core parity columns as a start point, to obtain the K₁ information bits. This can effectively reduce transmission resources occupied when the transmit end transmits information, and ensure decoding performance of the receive end.

In a possible implementation, when the first sparsity is less than or equal to a third threshold, C is equal to 0, or D is equal to 0.

In this embodiment of this application, when the first sparsity is less than or equal to the third threshold (which may also mean that a source is sparse), K₀ may be equal to 0. In other words, the transmit end needs to transmit only the parity bits to ensure that the receive end correctly obtains the K₀ information bits through decoding. This ensures decoding performance of the receive end, effectively expands a selectable range of a code rate, and reduces transmission resources occupied when the transmit end transmits information.

In a possible implementation, when the first sparsity is greater than the third threshold, C is greater than or equal to 5.

In this embodiment of this application, when the first sparsity is greater than the third threshold, a specific quantity of information bits are transmitted, to effectively ensure decoding performance of the receive end.

In a possible implementation, when the first sparsity is less than or equal to a fourth threshold, an initial code rate of the LDPC encoding is greater than or equal to 1.

In this embodiment of this application, when the first sparsity is small, the transmit end may use a code rate greater than or equal to 1. Therefore, on a premise of ensuring decoding performance of the receive end, transmission resources occupied when the transmit end transmits information can be effectively reduced, and transmission efficiency can be improved.

In a possible implementation, the method further includes: sending indication information, where the indication information indicates the first sparsity.

According to a second aspect, an embodiment of this application provides a decoding method. The method is applied to a receive end, and the method includes: obtaining a second bit sequence; determining, based on first sparsity and a code rate, that the second bit sequence includes K₁ information bits and N₁ parity bits, where K₁ is a nonnegative integer, and N₁ is a positive integer; and performing low-density parity-check LDPC decoding on the second bit sequence based on the first sparsity and the code rate, to obtain K₀ information bits, where K₀ is greater than K₁, and the first sparsity is used to indicate a proportion of 1 or 0 in the K₀ information bits.

In a possible implementation, the N₁ parity bits are determined based on A parity columns in a base graph BG1, or the N₁ parity bits are determined based on B parity columns in a base graph BG2, both A and B are positive integers, A is less than 46, and B is less than 41.

In a possible implementation, the A parity columns are determined in order from left to right by using core parity columns in the BG1 as a start point, or the B parity columns are determined in order from left to right by using core parity columns in the BG2 as a start point.

In a possible implementation, the K₁ information bits are determined based on C information columns in the base graph BG1, or the K₁ information bits are determined based on D information columns in the base graph BG2, and both C and D are nonnegative integers.

In a possible implementation, the C information columns are determined in order from right to left by using the core parity columns in the BG1 as a start point, or the D information columns are determined in order from right to left by using the core parity columns in the BG2 as a start point.

In a possible implementation, the method further includes: receiving indication information, where the indication information indicates the first sparsity.

It can be understood that, for specific descriptions and beneficial effects of the second aspect, refer to the first aspect. Details are not described herein again.

According to a third aspect, an embodiment of this application provides a communication apparatus, configured to perform the method according to any one of the first aspect or the possible implementations of the first aspect. The communication apparatus includes units that perform the method according to any one of the first aspect or the possible implementations of the first aspect. For example, the communication apparatus may include a processing unit and a transceiver unit.

The processing unit is configured to obtain a first bit sequence, where sparsity of the first bit sequence is first sparsity, the first sparsity is used to indicate a proportion of 1 or 0 in the first bit sequence, the first bit sequence includes K₀ information bits, and K₀ is a positive integer. The processing unit is further configured to perform low-density parity-check LDPC encoding based on the first bit sequence to obtain a second bit sequence, where the second bit sequence includes K₁ information bits and N₁ parity bits, a value of K₁ is determined based on the first sparsity, K₁ is less than K₀, K₁ is a nonnegative integer, and N₁ is a positive integer. The transceiver unit is configured to send the second bit sequence.

In a possible implementation, the processing unit is specifically configured to: if the first sparsity is less than or equal to a first threshold, perform LDPC encoding based on the first bit sequence to obtain the second bit sequence.

In a possible implementation, the processing unit is specifically configured to: perform LDPC encoding based on the first bit sequence to obtain a third bit sequence, where the third bit sequence includes K₀ information bits and N₀ parity bits, and N₀ is an integer greater than or equal to N₁; and perform, based on the first sparsity, at least one of the following: determine the N₁ parity bits from the N₀ parity bits, and determine the K₁ information bits from the K₀ information bits.

In a possible implementation, the N₁ parity bits are determined based on A parity columns in a base graph BG1, or the N₁ parity bits are determined based on B parity columns in a base graph BG2, both A and B are positive integers, A is less than 46, and B is less than 41.

In a possible implementation, the A parity columns are determined in order from left to right by using core parity columns in the BG1 as a start point, or the B parity columns are determined in order from left to right by using core parity columns in the BG2 as a start point.

In a possible implementation, when the first sparsity is less than or equal to a second threshold, the A parity columns do not include a 1^{st} column of extension parity columns in the BG1, and the B parity columns include a 1^{st} column of extension parity columns in the BG2.

In a possible implementation, when the first sparsity is greater than a second threshold, the A parity columns include a 1^{st} column of extension parity columns in the BG1, or the B parity columns include a 1^{st} column of extension parity columns in the BG2.

In a possible implementation, A is greater than or equal to 8.

In a possible implementation, B is greater than or equal to 5.

In a possible implementation, the K₁ information bits are determined based on C information columns in the base graph BG1, or the K₁ information bits are determined based on D information columns in the base graph BG2, and both C and D are nonnegative integers.

In a possible implementation, the C information columns are determined in order from right to left by using the core parity columns in the BG1 as a start point, or the D information columns are determined in order from right to left by using the core parity columns in the BG2 as a start point.

In a possible implementation, C is less than or equal to 20, or D is less than or equal to 8.

In a possible implementation, when the first sparsity is less than or equal to a third threshold, C is equal to 0, or D is equal to 0.

In a possible implementation, when the first sparsity is greater than the third threshold, C is greater than or equal to 5.

In a possible implementation, when the first sparsity is less than or equal to a fourth threshold, an initial code rate of the LDPC encoding is greater than or equal to 1.

In a possible implementation, the transceiver unit is further configured to send indication information, where the indication information indicates the first sparsity.

According to a fourth aspect, an embodiment of this application provides a communication apparatus, configured to perform the method according to any one of the second aspect or the possible implementations of the second aspect. The communication apparatus includes units that perform the method according to any one of the second aspect or the possible implementations of the second aspect. For example, the communication apparatus may include a processing unit and a transceiver unit.

The processing unit is configured to: obtain a second bit sequence; and determine, based on first sparsity and a code rate, that the second bit sequence includes K₁ information bits and N₁ parity bits, where K₁ is a nonnegative integer, and N₁ is a positive integer.

The processing unit is further configured to perform low-density parity-check LDPC decoding on the second bit sequence based on the first sparsity and the code rate, to obtain K₀ information bits, where K₀ is greater than K₁, and the first sparsity is used to indicate a proportion of 1 or 0 in the K₀ information bits.

In a possible implementation, the transceiver unit is further configured to receive indication information, where the indication information indicates the first sparsity.

For specific descriptions of the fourth aspect, refer to the second aspect. Details are not described herein again.

According to a fifth aspect, an embodiment of this application provides a communication apparatus. The communication apparatus includes a processor, configured to perform the method according to any one of the first aspect or the possible implementations of the first aspect. Alternatively, the processor is configured to execute a program stored in a memory. When the program is executed, the method according to any one of the first aspect or the possible implementations of the first aspect is performed.

In a possible implementation, the memory is located outside the communication apparatus.

In a possible implementation, the memory is located inside the communication apparatus.

In this embodiment of this application, the processor and the memory may be alternatively integrated into one device. In other words, the processor and the memory may be alternatively integrated together.

In a possible implementation, the communication apparatus further includes a transceiver. The transceiver is configured to receive a signal and/or send a signal.

According to a sixth aspect, an embodiment of this application provides a communication apparatus. The communication apparatus includes a processor, configured to perform the method according to any one of the second aspect or the possible implementations of the second aspect. Alternatively, the processor is configured to execute a program stored in a memory. When the program is executed, the method according to any one of the second aspect or the possible implementations of the second aspect is performed.

In a possible implementation, the memory is located outside the communication apparatus.

In a possible implementation, the memory is located inside the communication apparatus.

In this embodiment of this application, the processor and the memory may be alternatively integrated into one device. In other words, the processor and the memory may be alternatively integrated together.

In a possible implementation, the communication apparatus further includes a transceiver. The transceiver is configured to receive a signal and/or send a signal.

According to a seventh aspect, an embodiment of this application provides a chip. The communication apparatus includes a logic circuit and an interface. The logic circuit is coupled to the interface. The interface is configured to input a first bit sequence. The logic circuit is configured to perform LDPC encoding based on the first bit sequence, to obtain a second bit sequence. The interface is further configured to output the second bit sequence.

In a possible implementation, the logic circuit is specifically configured to: if first sparsity is less than or equal to a first threshold, perform LDPC encoding based on the first bit sequence to obtain the second bit sequence.

In a possible implementation, the logic circuit is specifically configured to: perform LDPC encoding based on the first bit sequence to obtain a third bit sequence, where the third bit sequence includes K₀ information bits and N₀ parity bits, and N₀ is an integer greater than or equal to N₁; and perform, based on the first sparsity, at least one of the following: determine N₁ parity bits from the N₀ parity bits, and determine K₁ information bits from the K₀ information bits.

In a possible implementation, the interface is further configured to output indication information, where the indication information indicates the first sparsity.

It can be understood that the communication apparatus described in this embodiment of this application may be referred to as a chip, an encoder, an apparatus having an encoding function, or the like. This is not limited in embodiments of this application.

According to an eighth aspect, an embodiment of this application provides a chip. The communication apparatus includes a logic circuit and an interface. The logic circuit is coupled to the interface. The interface is configured to input a second bit sequence. The logic circuit is configured to: determine, based on first sparsity and a code rate, that the second bit sequence includes K₁ information bits and N₁ parity bits; and perform LDPC decoding on the second bit sequence, to obtain K₀ information bits.

It can be understood that the communication apparatus described in this embodiment of this application may be referred to as a chip, a decoder, an apparatus having a decoding function, or the like. This is not limited in embodiments of this application.

According to a ninth aspect, an embodiment of this application provides a computer-readable storage medium. The computer-readable storage medium is configured to store a computer program. When the computer program is run on a computer, the method according to any one of the first aspect or the possible implementations of the first aspect is performed.

According to a tenth aspect, an embodiment of this application provides a computer-readable storage medium. The computer-readable storage medium is configured to store a computer program. When the computer program is run on a computer, the method according to any one of the second aspect or the possible implementations of the second aspect is performed.

According to an eleventh aspect, an embodiment of this application provides a computer program product. The computer program product includes a computer program or computer code (which may also be referred to as instructions). When the computer program or the computer code is run on a computer, the method according to any one of the first aspect or the possible implementations of the first aspect is performed.

According to a twelfth aspect, an embodiment of this application provides a computer program product. The computer program product includes a computer program or computer code (which may also be referred to as instructions). When the computer program or the computer code is run on a computer, the method according to any one of the second aspect or the possible implementations of the second aspect is performed.

According to a thirteenth aspect, an embodiment of this application provides a computer program. When the computer program is run on a computer, the method according to any one of the first aspect or the possible implementations of the first aspect is performed.

According to a fourteenth aspect, an embodiment of this application provides a computer program. When the computer program is run on a computer, the method according to any one of the second aspect or the possible implementations of the second aspect is performed.

According to a fifteenth aspect, an embodiment of this application provides a communication system. The communication system includes a transmit end and a receive end. The transmit end is configured to perform the method according to any one of the first aspect or the possible implementations of the first aspect, and the receive end is configured to perform the method according to any one of the second aspect or the possible implementations of the second aspect.

### BRIEF DESCRIPTION OF DRAWINGS

FIG. 1 is a diagram of an architecture of a communication system according to an embodiment of this application;
FIG. 2 is a diagram of an architecture of a communication system according to an embodiment of this application;
FIG. 3a is a diagram of a structure of a BG1 according to an embodiment of this application;
FIG. 3b is a diagram of a structure of a BG2 according to an embodiment of this application;
FIG. 3c is a diagram of a relationship between a code rate (code rate) and a quantity of bits (bits) of a code block (code block, CB) according to an embodiment of this application;
FIG. 4 is a schematic flowchart of an encoding method and a decoding method according to an embodiment of this application;
FIG. 5a is a diagram of a sequence of determining K₁ information bits and N₁ parity bits based on a BG1 according to an embodiment of this application;
FIG. 5b is a diagram of a sequence of determining K₁ information bits and N₁ parity bits based on a BG2 according to an embodiment of this application;
FIG. 6 is a diagram of a principle of a coding method according to an embodiment of this application;
FIG. 7 is a diagram of transmission paths based on different sparsity ranges of a BG1 according to an embodiment of this application;
FIG. 8a is a diagram of a JSCC transmission path based on an NR BG1 when p1=0.05 according to an embodiment of this application;
FIG. 8b is a diagram of simulation results according to an embodiment of this application;
FIG. 9a is a diagram of a JSCC transmission path based on an NR BG1 when p1=0.1 according to an embodiment of this application;
FIG. 9b is a diagram of simulation results according to an embodiment of this application;
FIG. 10a is a diagram of JSCC transmission paths based on an NR BG1 when p1=0.2 according to an embodiment of this application;
FIG. 10b is a diagram of simulation results according to an embodiment of this application;
FIG. 11a is a diagram of JSCC transmission paths based on an NR BG1 when p1=0.3 according to an embodiment of this application;
FIG. 11b is a diagram of simulation results according to an embodiment of this application;
FIG. 12 is a diagram of transmission paths based on different sparsity ranges of a BG2 according to an embodiment of this application;
FIG. 13a is a diagram of a JSCC transmission path based on an NR BG2 when p1=0.05 according to an embodiment of this application;
FIG. 13b is a diagram of simulation results according to an embodiment of this application;
FIG. 14a is a diagram of a JSCC transmission path based on an NR BG2 when p1=0.10 according to an embodiment of this application;
FIG. 14b is a diagram of simulation results according to an embodiment of this application;
FIG. 15a is a diagram of a JSCC transmission path based on an NR BG2 when p1=0.20 according to an embodiment of this application;
FIG. 15b is a diagram of simulation results according to an embodiment of this application;
FIG. 16a is a diagram of JSCC transmission paths based on an NR BG2 when p1=0.30 according to an embodiment of this application;
FIG. 16b is a diagram of simulation results according to an embodiment of this application;
FIG. 17 is a diagram of a structure of a communication apparatus according to an embodiment of this application;
FIG. 18 is a diagram of a structure of a communication apparatus according to an embodiment of this application; and
FIG. 19 is a diagram of a structure of a chip according to an embodiment of this application.

### DESCRIPTION OF EMBODIMENTS

To make the objectives, technical solutions, and advantages of this application clearer, the following further describes this application with reference to accompanying drawings.

In the specification, claims, and accompanying drawings of this application, terms "first", "second", and the like are merely intended to distinguish between different objects but do not indicate a particular order. In addition, terms "include", "have", and any other variations thereof are intended to cover non-exclusive inclusion. For example, processes, methods, systems, products, devices, or the like that include a series of steps or units are not limited to the listed steps or units, but optionally further include unlisted steps, units, or the like, or optionally further include other steps or units inherent to these processes, methods, products, devices, or the like.

An "embodiment" mentioned in this specification means that a particular feature, structure, or characteristic described with reference to the embodiment may be included in at least one embodiment of this application. The phrase shown at various locations in this specification may not necessarily refer to a same embodiment, and is not an independent or optional embodiment exclusive from other embodiments. A person skilled in the art can explicitly and implicitly understand that embodiments described in this specification may be combined with other embodiments.

In this application, "at least one item (piece)" means one or more items (pieces), "a plurality of" means two or more, "at least two items (pieces)" means two, three, or more items (pieces), and "and/or" describes an association relationship for describing associated objects and indicates that three relationships may exist. For example, A and/or B may indicate the following three cases: Only A exists, only B exists, and both A and B exist. A and B each may be in a singular or plural form. A character "/" generally indicates an "or" relationship between associated objects. "At least one of the following items (pieces)" or a similar expression thereof means any combination of these items. For example, at least one item (piece) of a, b, or c may represent a, b, c, a-b, a-c, b-c, or a-b-c.

The technical solutions provided in embodiments of this application can be applied to various communication systems, for example, an internet of things (internet of things, IoT) system, a narrowband internet of things (narrowband internet of things, NB-IoT) system, a long term evolution (long term evolution, LTE) system, a 5th generation (5th-generation, 5G) communication system, and a new communication system that emerges in future communication development.

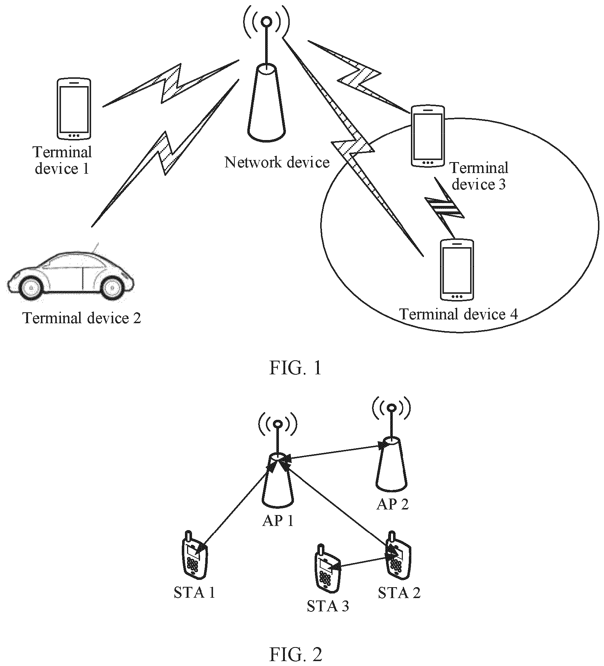

The technical solutions provided in embodiments of this application can also be applied to non-terrestrial network (non-terrestrial network, NTN) communication (which may also be referred to as non-terrestrial network communication), machine type communication (machine type communication, MTC), long term evolution-machine type communication (long term evolution-machine, LTE-M), a device-to-device (device-to-device, D2D) network, a machine-to-machine (machine-to-machine, M2M) network, an internet of things (internet of things, IoT) network, an industrial internet, or another network. The IoT network may include, for example, an internet of vehicles. Communication modes in an internet of vehicles system are collectively referred to as vehicle-to-everything (vehicle-to-everything, V2X, where X can stand for anything). For example, the V2X may include vehicle-to-vehicle (vehicle-to-vehicle, V2V) communication, vehicle-to-infrastructure (vehicle-to-infrastructure, V2I) communication, vehicle-to-pedestrian (vehicle-to-pedestrian, V2P) communication, vehicle-to-network (vehicle-to-network, V2N) communication, or the like. For example, in FIG. 1 shown below, terminal devices may communicate with each other by using the D2D technology, the M2M technology, the V2X technology, or the like.

The technical solutions provided in embodiments of this application can also be applied to a wireless local area network (wireless local area network, WLAN) system, for example, Wi-Fi. For example, methods provided in embodiments of this application are applicable to the Institute of Electrical and Electronics Engineers (institute of electrical and electronics engineers, IEEE) 802.11 series protocols, such as the 802.11a/b/g protocol, the 802.11n protocol, the 802.11ac protocol, the 802.11ax protocol, the 802.11be protocol, and a next-generation protocol. Other applicable protocols are not enumerated herein. For another example, the methods are also applicable to a wireless personal area network (wireless personal area network, WPAN) based on an ultra wideband (ultra wideband, UWB) technology, such as the 802.15.4a protocol, the 802.15.4z protocol, and the 802.15.4ab protocol in the IEEE 802.15 series protocols, and a future generation of UWB WPAN protocol. Other applicable protocols are not enumerated herein. A person skilled in the art easily understands that, various aspects in embodiments of this application may be extended to other networks using various standards or protocols, for example, Bluetooth (Bluetooth), a high performance wireless LAN (high performance radio LAN, HIPERLAN) (which is a wireless standard similar to the IEEE 802.11 standard, and is mainly used in Europe), a wide area network (WAN), or other networks known or developed in the future. Therefore, regardless of a coverage area and a wireless access protocol that are used, the technical solutions provided in embodiments of this application are applicable to any suitable wireless network.

In a possible implementation, FIG. 1 is a diagram of an architecture of a communication system according to an embodiment of this application. As shown in FIG. 1, the communication system may include at least one network device and at least one terminal device, for example, a terminal device 1 to a terminal device 4 in FIG. 1. For example, the terminal device 3 and the terminal device 4 shown in FIG. 1 may directly communicate with each other. For example, terminal devices may directly communicate with each other by using the D2D technology. The terminal device 1 to the terminal device 4 each may communicate with the network device. It can be understood that the terminal device 3 and the terminal device 4 may directly communicate with the network device, or may indirectly communicate with the network device, for example, communicate with the network device through another terminal device (not shown in FIG. 1). It should be understood that FIG. 1 shows an example of one network device, a plurality of terminal devices, and communication links between communication devices. Optionally, the communication system may include a plurality of network devices, and another quantity of terminal devices, for example, more or fewer terminal devices, may be included in a coverage area of each network device. This is not limited in embodiments of this application. The following details the terminal device and the network device.

The terminal device is an apparatus having wireless sending and receiving functions. The terminal device may communicate with an access network device (or may be referred to as an access device) in a radio access network (radio access network, RAN). The terminal device may also be referred to as user equipment (user equipment, UE), an access terminal, a terminal (terminal), a subscriber unit (subscriber unit), a subscriber station, a mobile station, a remote station, a remote terminal, a mobile device, a user terminal, a user agent, a user apparatus, or the like. In a possible implementation, the terminal device may be deployed on land, including an indoor, outdoor, handheld, or vehicle-mounted device; or may be deployed on the water (for example, a ship). In a possible implementation, the terminal device may be a handheld device having a wireless communication function, a vehicle-mounted device, a wearable device, a sensor, a terminal in an internet of things, a terminal in an internet of vehicles, an uncrewed aerial vehicle device, a terminal device in any form in a 5G network or a future network, or the like. This is not limited in embodiments of this application. It can be understood that the terminal device described in this embodiment of this application may include a vehicle (for example, a car) in the internet of vehicles, and may also include a vehicle-mounted device, a vehicle-mounted terminal, or the like in the internet of vehicles. A specific form of the terminal device used in the internet of vehicles is not limited in embodiments of this application. It can be understood that the terminal devices described in this embodiment of this application may communicate with each other through D2D, V2X, M2M, or the like. A communication method between the terminal devices is not limited in embodiments of this application.

The network device may be an apparatus that is deployed in the radio access network and that provides a wireless communication service for the terminal device. The network device may also be referred to as an access network device, an access device, a RAN device, or the like. For example, the network device may be a next generation NodeB (next generation NodeB, gNB), a next generation evolved NodeB (next generation evolved NodeB, ng-eNB), a network device in 6G communication, or the like. The network device may be any device having wireless sending and receiving functions, and includes but is not limited to the base station shown above (including a base station deployed on a satellite). Alternatively, the network device may be an apparatus that has a base station function in 6G. Optionally, the network device may be an access node, a wireless relay node, a wireless backhaul node, or the like in a wireless local area network (wireless fidelity, Wi-Fi) system. Optionally, the network device may be a radio controller in a cloud radio access network (cloud radio access network, CRAN) scenario. Optionally, the network device may be a wearable device, a vehicle-mounted device, or the like. Optionally, the network device may be a small cell, a transmission reception point (transmission reception point, TRP) (or may be referred to as a transmission point), or the like. It can be understood that the network device may be alternatively a base station, a satellite, or the like in a future evolved public land mobile network (public land mobile network, PLMN). The network device may be alternatively a communication apparatus or the like functioning as a base station in a non-terrestrial communication system, D2D, V2X, or M2M. A specific type of the network device is not limited in embodiments of this application. In systems using different radio access technologies, names of communication apparatuses having functions of network devices may be different, and are not enumerated in this embodiment of this application. Optionally, in some deployments of a network device, the network device may include a central unit (central unit, CU), a distributed unit (distributed unit, DU), and the like. In some other deployments of a network device, the CU may be further divided into a CU-control plane (control plane, CP), a CU-user plane (user plane, UP), and the like. In still some other deployments of a network device, the network device may be alternatively an open radio access network (open radio access network, ORAN) architecture or the like. Specific deployment manners of the network devices are not limited in embodiments of this application.

In another possible implementation, FIG. 2 is a diagram of an architecture of a communication system according to an embodiment of this application. The communication system may include one or more APs and one or more STAs. FIG. 2 shows two access points: an AP 1 and an AP 2, and three stations: a STA 1, a STA 2, and a STA 3. The one or more APs may communicate with the one or more STAs. Certainly, APs may communicate with each other, and STAs may communicate with each other. For example, simultaneous communication between one AP and a plurality of STAs may include: downlink transmission in which one AP sends a signal to a plurality of STAs simultaneously, or uplink transmission in which a plurality of STAs simultaneously send a signal to one AP. In addition, the technical solutions provided in embodiments of this application can also be applied to similar non-standard transmission systems.

It can be understood that, in FIG. 2, an example is used in which the STA is a mobile phone and the AP is a router. This does not mean that types of the AP and the STA in embodiments of this application are limited. Moreover, FIG. 2 shows only two APs and three STAs as examples. However, there may be more or fewer APs or STAs. This is not limited in embodiments of this application. The following details the access point and the station.

The access point is an apparatus having a wireless communication function, supports communication or sensing by using a WLAN protocol, has a function of communicating with or sensing another device (for example, a station or another access point) in a WLAN network, and certainly may also have a function of communicating with or sensing other devices. Alternatively, the access point is equivalent to a bridge connecting a wired network and a wireless network. Main functions of the access point are to connect wireless network clients together, and then connect the wireless network to an Ethernet. In the WLAN system, the access point may be referred to as an access point station (AP STA). The apparatus having the wireless communication function may be an entire device, or may be a chip, a processing system, or the like installed in an entire device. The device in which the chip or the processing system is installed can implement methods, functions, and the like in embodiments of this application under the control of the chip or the processing system. The AP in this embodiment of this application is an apparatus that provides a service for the STA, and can support the 802.11 series protocols, subsequent protocols, or the like. For example, the access point may be an access point for a terminal (for example, a mobile phone) to access a wired (or wireless) network and is mainly deployed at home, or inside a building or a campus, and has a typical coverage radius of tens to hundreds of meters. Certainly, the access point may be alternatively deployed outdoors. For another example, the AP may be a communication entity, like a communication server, a router, a switch, or a bridge, or the AP may include various forms of macro base stations, micro base stations, relay stations, and the like. Certainly, the AP may be alternatively a chip or a processing system in these devices in various forms, to implement the methods and the functions in embodiments of this application. For descriptions of the access point, refer to the descriptions of the network device in FIG. 1. Details are not described herein again.

The station is an apparatus having a wireless communication function, supports communication or sensing by using the WLAN protocol, and has a capability of communicating with or sensing another station or an access point in the WLAN network. In the WLAN system, the station may be referred to as a non-access point station (non-access point station, non-AP STA). For example, the STA is any user communication device that allows a user to communicate with or sense the AP and then communicate with the WLAN. The apparatus having the wireless communication function may be an entire device, or may be a chip, a processing system, or the like installed in an entire device. The device in which the chip or the processing system is installed can implement the methods and the functions in embodiments of this application under the control of the chip or the processing system. For example, the station may be a wireless communication chip, a wireless sensor, a wireless communication terminal, or the like, and may also be referred to as a user. For another example, the station may be a mobile phone, a tablet computer, a set-top box, a smart television, a smart wearable device, a vehicle-mounted communication device, a computer, or the like supporting a Wi-Fi communication function. For descriptions of the station, refer to the descriptions of the terminal device in FIG. 1. Details are not described herein again.

Network architectures and service scenarios that are described in embodiments of this application are intended to describe the technical solutions in embodiments of this application more clearly, but do not constitute any limitation on the technical solutions provided in embodiments of this application. A person of ordinary skill in the art can know that, as the network architectures evolve and new service scenarios emerge, the technical solutions provided in embodiments of this application are also applicable to similar technical issues.

A new radio (new radio, NR) LDPC code has been used as a channel coding scheme for a 5G data channel, and the NR LDPC code can be applied to a channel coding scenario. Therefore, there is large room for improving performance of data transmission performed by directly using the NR LDPC code for a biased source in a JSCC scenario. If a set of JSCC encoding and decoding schemes is specially introduced for the biased source in the JSCC scenario, performance in the scenario with the biased source can be greatly improved. However, in the new JSCC encoding and decoding schemes, an additional new encoding/decoding module needs to be introduced based on an original encoding/decoding module. As a result, overall implementation complexity of the encoding/decoding module of a system is high. It can be understood that the encoding/decoding module shown herein may be a module having an encoding function and a module having a decoding function in a communication apparatus.

In view of this, to improve JSCC transmission performance of the system in the scenario with the biased source without significantly increasing implementation complexity of the system, embodiments of this application provide an encoding method, a decoding method, and an apparatus for an NR LDPC code-based JSCC transmission scheme. In this way, parity-check matrices such as a BG1 and a BG2 of NR LDPC can be effectively used, no new parity-check matrix is added, and complexity of the encoding/decoding module is not increased.

Before the methods provided in embodiments of this application are described, the following briefly describes the BG1 and the BG2. It can be understood that the following descriptions of the BG1 and the BG2 are merely examples. For other descriptions of the BG1 and the BG2, refer to a related standard or protocol, or the like. This is not limited in embodiments of this application.

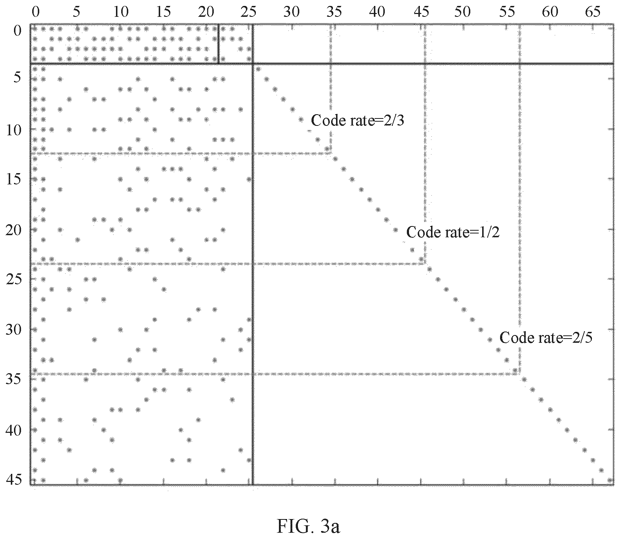

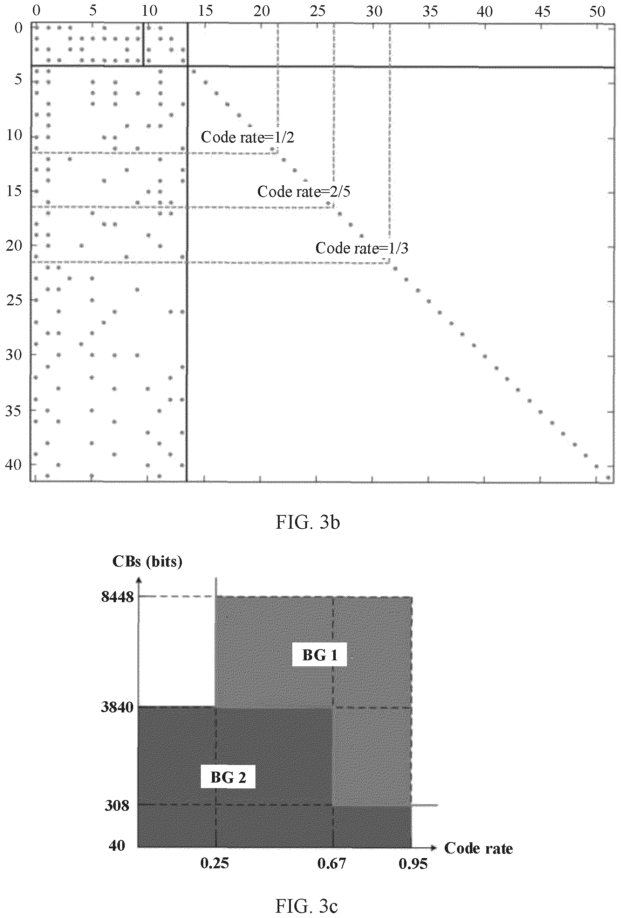

FIG. 3a is a diagram of a structure of a BG1 according to an embodiment of this application. FIG. 3b is a diagram of a structure of a BG2 according to an embodiment of this application. FIG. 3c is a diagram of a relationship between a code rate and a quantity of bits (bits) of a CB according to an embodiment of this application. For example, an applicable code length of the BG1 is information bits: K=308 bits to 8448 bits, and a code rate R is 0.25≤R≤0.95; and an applicable code length of the BG2 is information bits: K=40 bits to 3840 bits, and a code rate R is 0.20≤R≤0.95. It can be learned that the BG1 is mainly targeted for a scenario with a medium or high code rate and a large data packet, and the BG2 is mainly targeted for a scenario with a medium or low code rate and a short data packet. In embodiments of this application, an encoding method and a decoding method that are applicable to a biased source are designed for both the BG1 and the BG2. Based on both the BG1 and the BG2, performance improvement in the JSCC scenario can be achieved, and a high complexity problem of the system caused by introduction of a new parity-check matrix is effectively alleviated.

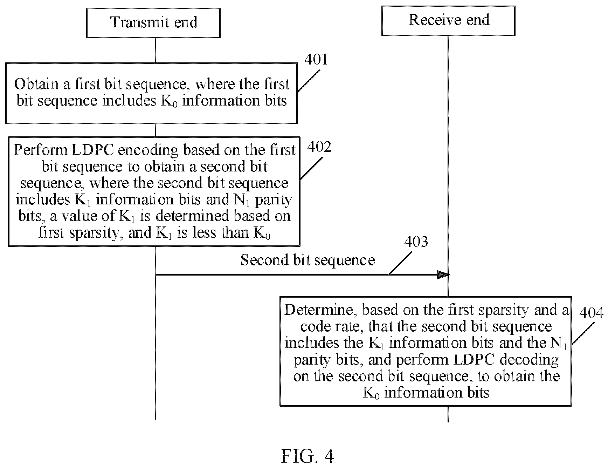

FIG. 4 is a schematic flowchart of an encoding method and a decoding method according to an embodiment of this application. The methods can be applied to a transmit end and a receive end. The transmit end can be understood as an end that sends information, and the receive end can be understood as an end that receives information. Alternatively, the transmit end can be understood as an encoder side, and the receive end can be understood as a decoder side. For example, the transmit end may be a network device (for example, a base station), and the receive end may be a terminal device; the transmit end may be an AP, and the receive end may be a STA; both the transmit end and the receive end may be terminal devices (or STAs); or the like. This is not limited in embodiments of this application. For a communication system to which this embodiment of this application is applied, refer to FIG. 1 and FIG. 2. Details are not described herein again. As shown in FIG. 4, the methods include the following steps.

401: The transmit end obtains a first bit sequence, where the first bit sequence includes K₀ information bits.

Sparsity of the first bit sequence is first sparsity, the first sparsity is used to indicate a proportion of 1 or 0 in the first bit sequence, the first bit sequence includes the K₀ information bits, and K₀ is a positive integer. The first bit sequence can be understood as a to-be-sent bit sequence obtained by the transmit end. For example, the first bit sequence can be understood as a bit sequence including an information amount, or a bit sequence that needs to be transmitted. Optionally, it can be understood that the first bit sequence is composed of the K₀ information bits. It can be understood that the K₀ information bits shown above may include a cyclic redundancy check (cyclic redundancy check, CRC). Certainly, the K₀ information bits may alternatively not include the CRC. In this case, in a subsequent process of processing the first bit sequence, the transmit end may not add the CRC or may add the CRC. This is not limited in embodiments of this application. The first bit sequence may be a bit sequence without source compression. Certainly, the first bit sequence may be alternatively a bit sequence obtained through source compression.

The sparsity may be used to measure a proportion of 1 or 0 in a bit sequence, and the first sparsity is a proportion of 1 or 0 in the first bit sequence. For example, the sparsity may also be referred to as source priori information, a source priori probability, or the like. This is not limited in embodiments of this application. For ease of description, the first sparsity is represented by p1 below.

402: The transmit end performs LDPC encoding based on the first bit sequence to obtain a second bit sequence, where the second bit sequence includes K₁ information bits and N₁ parity bits, a value of K₁ is determined based on the first sparsity, and K₁ is less than K₀.

Generally, in another LDPC encoding scheme, after performing LDPC encoding, the transmit end obtains K₀ information bits, that is, a quantity of information bits obtained through the LDPC encoding is the same as the quantity of information bits before the LDPC encoding. Parity bits obtained based on a code rate may be obtained based on 46 parity columns in a BG1, or may be obtained based on 41 parity columns in a BG2. In addition, in the other LDPC encoding schemes, after obtaining the K₀ information bits and a specific quantity of parity bits through encoding, the transmit end usually performs rate matching in a unified order, for example, in order from left to right starting from the BG1 matrix. However, in the LDPC encoding scheme provided in this embodiment of this application, the second bit sequence obtained through the LDPC encoding may include the K₁ information bits and the N₁ parity bits. The value of K₁ is determined based on the first sparsity, K₁ is less than K₀, K₁ is a nonnegative integer, and N₁ is a positive integer. The N₁ parity bits may be obtained based on 46 parity columns in a BG1, may be obtained based on 41 parity columns in a BG2, may be determined based on some parity columns in the BG1, or may be determined based on some parity columns in the BG2.

It should be noted that in the other LDPC encoding schemes, the transmit end may obtain the K₀ information bits through the LDPC encoding, and then perform rate matching on the K₀ information bits to obtain K₁ information bits. In other words, in the other LDPC encoding, the K₀ information bits obtained through the LDPC encoding are the same as the information bits before the LDPC encoding. However, in this embodiment of this application, the quantity of information bits obtained through the LDPC encoding is less than the quantity of information bits before the LDPC encoding. Certainly, the second bit sequence shown above may be directly obtained through the LDPC encoding, or may be obtained through the LDPC encoding and rate matching. For example, the quantity of information bits obtained by performing the LDPC encoding on the K₀ information bits may be K₀, but rate matching is performed on the K₀ information bits in a manner from right to left starting from core parity columns, to determine the K₁ information bits. For another example, the K₁ information bits may be directly obtained by performing the LDPC encoding on the K₀ information bits. In other words, the LDPC encoding described in this embodiment of this application is different from the other LDPC encoding. Even if the K₀ information bits are obtained through the LPDC encoding, a rate matching manner of the K₀ information bits is different from that in the other LDPC encoding. For specific descriptions of rate matching, refer to transmission paths in the following implementation 1 to implementation 8. Details are not described herein.

In a possible implementation, that the transmit end performs LDPC encoding based on the first bit sequence to obtain a second bit sequence includes:
If the first sparsity is less than or equal to a first threshold, the transmit end performs LDPC encoding based on the first bit sequence to obtain the second bit sequence.

When the first sparsity is less than or equal to the first threshold, the transmit end performs LDPC encoding based on the first bit sequence, to ensure that the receive end can effectively decode the second bit sequence to obtain the K₀ information bits. Generally, when the first sparsity is less than or equal to the first threshold, it indicates that the first bit sequence is sparse. In this case, the LDPC encoding provided in this embodiment of this application (for example, K₁ is less than K₀) is used, so that desirable decoding performance of the receive end can be ensured, and a block error rate (block error rate, BLER) for decoding is low. According to the methods described in this embodiment of this application, at an SNR, a code rate greater than 1 can be obtained with excellent performance. For example, a higher code rate indicates a smaller quantity of transmitted bits, fewer occupied channel transmission resources, and higher transmission efficiency. In addition, decoding performance of the receive end is effectively ensured. Moreover, transmission performance at a medium or low SNR can also be improved.

For example, the first threshold may be less than or equal to 0.3, the first threshold may be less than or equal to 0.25, or the first threshold may be less than or equal to 0.2. Specific values of the first threshold are not enumerated in this embodiment of this application.

It can be understood that the value of the first threshold may vary with a base graph. For example, the BG1 and the BG2 are corresponding to different first thresholds, or both the BG1 and the BG2 use a same first threshold. This is not limited in embodiments of this application.

It should be noted that a quantity of information bits obtained when the transmit end performs LDPC encoding based on the first sparsity may also be K₀. When the first sparsity is greater than the first threshold, the transmit end may perform LDPC encoding based on the first bit sequence to obtain the K₀ information bits. In this way, decoding performance of the receive end is ensured.

In a possible implementation, that the transmit end performs LDPC encoding based on the first bit sequence to obtain the second bit sequence includes:
The transmit end performs LDPC encoding based on the first bit sequence to obtain a third bit sequence, where the third bit sequence includes K₀ information bits and N₀ parity bits, and N₀ is an integer greater than or equal to N₁. Then, the transmit end performs at least one of the following: determines the N₁ parity bits from the N₀ parity bits based on the first sparsity, and determines the K₁ information bits from the K₀ information bits based on the first sparsity.

For example, the N₀ parity bits may be obtained based on all parity columns in the BG1, or may be obtained based on all parity columns in the BG2. For example, the transmit end may perform LDPC encoding based on the first bit sequence and the 46 parity columns (including core parity columns) in the BG1 or the 41 parity columns (including four core parity columns) in the BG2, to obtain the K₀ information bits and the N₀ parity bits; and then select the K₁ information bits from the K₀ information bits, and select the N₁ parity bits from the N₀ parity bits. It can be understood that N₀ described in this embodiment of this application may vary with a base graph. For example, N₀ obtained based on the 45 parity columns included in the BG1 and an expansion factor may be different from N₀ obtained based on the 41 parity columns included in the BG2 and the expansion factor. Likewise, for a relationship among N₁, the BG1, and the BG2, adaptively refer to a relationship among N₀, the BG1, and the BG2.

It should be noted that, after obtaining the K₀ information bits and the N₀ parity bits, the transmit end may determine the N₁ parity bits from the N₀ parity bits; or determine the N₁ parity bits from the N₀ parity bits, and determine the K₁ information bits from the K₀ information bits. Certainly, the transmit end may further perform LDPC encoding to obtain the K₀ information bits and the N₁ parity bits; obtain the N₁ parity bits; or obtain the K₁ information bits and the N₀ parity bits, and then determine the N₁ parity bits from the N₀ parity bits. This is not limited in embodiments of this application.

The following describes a method for determining the N₁ parity bits from the N₀ parity bits and a method for determining K₁ parity bits from the K₀ information bits by using an example in which the N₁ parity bits are obtained based on A parity columns in the BG1 or the N₁ parity bits are obtained based on B parity columns in the BG2, and describes a method for determining the K₁ information bits from the K₀ information bits by using an example in which the K₁ information bits are obtained based on C information columns in the BG1 or the K₁ information bits are obtained based on D information columns in the BG2. A, B, C, and D are all positive integers. For example, the transmit end may reserve the N₁ parity bits and the K₁ parity bits in a rate matching manner, like a puncturing manner. A specific manner of reserving the N₁ parity bits and the K₁ parity bits through rate matching may be described as follows.

In a possible implementation, based on the first sparsity, the transmit end may randomly select the K₁ information bits from the K₀ information bits, and select the N₁ parity bits from the N₀ parity bits.

When the transmit end randomly performs selection, a relationship between K₀ and K₁ and a relationship between N₀ and N₁ can still satisfy relationships described below in this embodiment of this application. In other words, for a relationship among the first sparsity, K₀, K₁, N₀, and N₁, refer to the following descriptions.

In another possible implementation, based on the first sparsity and according to a specific rule, the transmit end may select the K₁ information bits from the K₀ information bits, and select the N₁ parity bits from the N₀ parity bits.

In an example, the transmit end may determine the A parity columns in order from left to right by using the core parity columns in the BG1 as a start point, where the A parity columns are corresponding to the N₁ parity bits; or the transmit end may determine the B parity columns in order from left to right by using the core parity columns in the BG2 as a start point, where the B parity columns are corresponding to the N₁ parity bits. In other words, the A parity columns are determined in order from left to right by using the core parity columns in the BG1 as a start point, or the B parity columns are determined in order from left to right by using the core parity columns in the BG2 as a start point. In this embodiment of this application, the A parity columns or the B parity columns are determined in order from left to right by using the core parity columns as a start point. This can ensure that the receive end can correctly obtain the K₀ information bits through decoding based on the N₁ parity bits, thereby ensuring decoding performance.

In another example, the transmit end may determine the C information columns in order from right to left by using the core parity columns in the BG1 as a start point, where the C information columns are corresponding to the K₁ information bits; or the transmit end may determine the D information columns in order from right to left by using the core parity columns in the BG2 as a start point, where the D information columns are corresponding to the K₁ information bits. In other words, the C information columns are determined in order from right to left by using the core parity columns in the BG1 as a start point, or the D information columns are determined in order from right to left by using the core parity columns in the BG2 as a start point. In this embodiment of this application, C parity columns or D parity columns are determined in order from right to left by using the core parity columns as a start point. This can ensure that the receive end can correctly obtain the K₀ information bits through decoding based on the K₁ information bits, thereby ensuring decoding performance.

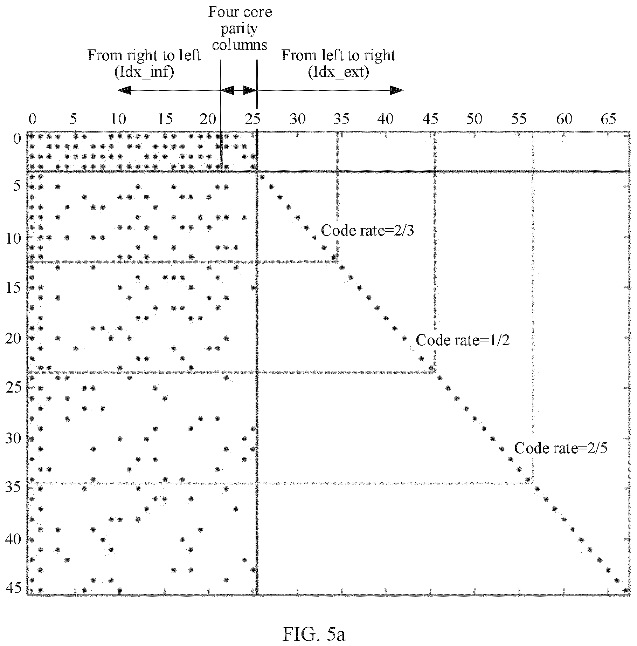

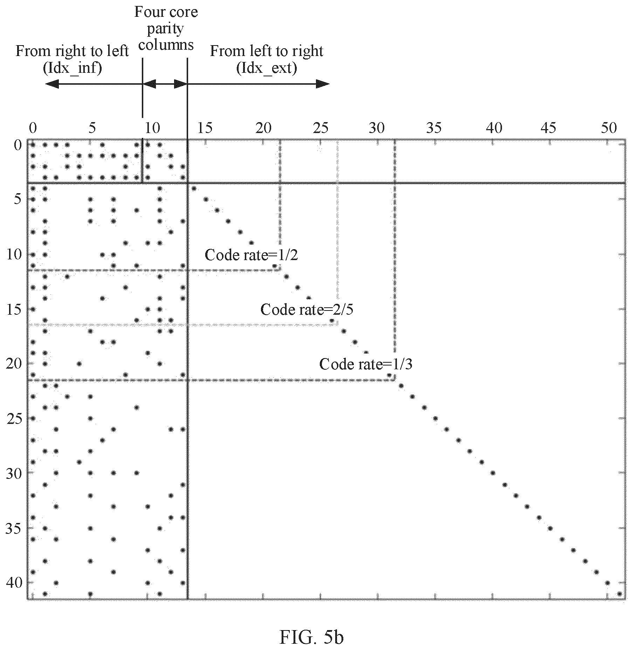

For ease of differentiation, parity columns in the BG1 may be divided into core parity columns and extension parity columns. The core parity columns may be a 4×4 square matrix shown in FIG. 5a and FIG. 5b, and the extension parity columns may be an Idx_ext part shown in FIG. 5a and FIG. 5b.

FIG. 5a is a diagram of a sequence of determining K₁ information bits and N₁ parity bits based on a BG1 according to an embodiment of this application. FIG. 5b is a diagram of a sequence of determining K₁ information bits and N₁ parity bits based on a BG2 according to an embodiment of this application. As shown in FIG. 5a and FIG. 5b, the transmit end may determine the N₁ parity bits in order from left to right starting from four core parity columns, and determine the K₁ information bits in order from right to left starting from the four core parity columns. Alternatively, it can be understood that for a transmission path, both a parity bit part (that is, a part corresponding to Idx_ext shown in FIG. 5a and FIG. 5b, starting from left to right) and an information bit part (that is, a part corresponding to Idx_inf shown in FIG. 5a and FIG. 5b, starting from right to left) are extended based on the four core parity columns. The transmission path described in this embodiment of this application can be understood as a path for determining the A parity columns or the B parity columns and determining the C information columns or the D information columns by the transmit end, or can be understood as a path for sending information bits and parity bits by the transmit end. This is not limited in embodiments of this application. For example, the transmission path may also be referred to as a code rate extended path, an extended transmission path, or the like. A specific name of the transmission path is not limited in embodiments of this application.

It should be noted that, based on a relationship between the second bit sequence and the third bit sequence, the transmit end may first perform LDPC encoding to obtain the third bit sequence, and then determine the second bit sequence from the third bit sequence, to obtain the K₁ information bits and the N₁ parity bits. Certainly, the transmit end may alternatively obtain the second bit sequence directly through LDPC encoding, for example, obtain, based on the parity columns or the information columns in the BG1 (or the BG2) and the expansion factor, the K₁ information bits and the N₁ parity bits that meet a requirement of the transmission path. In other words, the transmit end may perform LDPC encoding based on some parity columns and/or some information columns and the K₀ information bits, to obtain the K₁ information bits and the N₁ parity bits. Alternatively, it can be understood that the transmit end directly performs LDPC encoding to obtain the second bit sequence, instead of first obtaining the third bit sequence and then obtaining the second bit sequence based on the third bit sequence.

That the value of K₁ shown above is determined based on the first sparsity includes the following several implementations:
In a first manner, when the first sparsity is less than or equal to the first threshold, K₁ is less than K₀. Certainly, when the first sparsity is greater than the first threshold, K₁ may be equal to K₀.

In a second manner, when the first sparsity is less than or equal to the first threshold and the first sparsity satisfies different conditions, values of K₁ may be different and values of N₁ may be different. For example, the first sparsity, A, B, C, and D may satisfy at least one of the following conditions:
Condition 1: When the first sparsity is less than or equal to a second threshold, the A parity columns do not include a 1^{st} column of the extension parity columns in the BG1. For ease of description, the 1^{st} column of the extension parity columns is represented by a row-column (row-column, RC)-1 below. The B parity columns may include an RC-1 of the BG2. Certainly, regardless of whether the A parity columns include the RC-1 or whether the B parity columns include the RC-1, decoding performance of the receive end is desirable. However, when the A parity columns do not include the RC-1 of the BG1, and the B parity columns include the RC-1, decoding performance of the receive end can be further improved.
Condition 2: When the first sparsity is greater than a second threshold, the A parity columns include an RC-1 of the BG1, and the B parity columns include an RC-1 of the BG2.
Condition 3: When the first sparsity is less than or equal to a third threshold, D=0, that is, K₁=0. The transmit end needs to transmit only the parity bits to effectively ensure that the receive end correctly obtains the K₀ information bits through decoding. This ensures decoding performance of the receive end, effectively expands a selectable range of the code rate, and reduces transmission resources occupied when the transmit end transmits information. It can be understood that D=0 shown herein is only an optional range. If there are sufficient transmission resources, when the first sparsity is less than or equal to the third threshold, the transmit end may alternatively transmit the information bits.
Condition 4: D is less than or equal to 8. Certainly, the transmit end may alternatively transmit more information bits, for example, D is less than or equal to 10.
Condition 5: When the first sparsity is less than or equal to a third threshold, C=0, that is, K₁=0.
Condition 6: When the first sparsity is less than or equal to a second threshold, C=0, that is, K₁=0.
Condition 7: C is less than or equal to 20. Certainly, the transmit end may alternatively transmit more information bits, for example, C is less than or equal to 22. For the condition 4 and the condition 7, the transmit end initially may perform encoding based on all information columns, but does not transmit all information bits; instead, the transmit end performs encoding based on the C information columns determined from the BG1 or the D information columns determined from the BG2 in order from right to left by using the core parity columns as a start point, to obtain the K₁ information bits. This can effectively reduce transmission resources occupied when the transmit end transmits information, and ensure decoding performance of the receive end.
Condition 8: When the first sparsity is greater than a third threshold, C is greater than or equal to 5, or C is greater than or equal to 15. A quantity of parity columns when C is greater than or equal to 5 may be greater than a quantity of parity columns when C is greater than or equal to 15. When the first sparsity is greater than the third threshold, a specific quantity of information bits are transmitted, to effectively ensure decoding performance of the receive end. If the quantity of information bits is excessively small, the receive end may fail in performing decoding correctly, or decoding efficiency of the receive end is low. Therefore, when a source is not quite sparse, that is, when the first sparsity is greater than the third threshold, the transmit end may transmit a specific quantity of information bits, to ensure decoding performance of the receive end.
Condition 9: A is greater than or equal to 8.
Condition 10: B is greater than or equal to 5. For the condition 9 and the condition 10, the parity bits obtained when A is greater than or equal to 8 or the parity bits obtained when B is greater than or equal to 5 can ensure decoding performance of the receive end on while occupying as few transmission resources as possible by the transmit end, and can still be used to effectively obtain the K₀ information bits through decoding.
Condition 11: When the first sparsity is less than or equal to a fourth threshold, an initial code rate is greater than or equal to 1. In other words, when a source is sparse, the transmit end may select an initial code rate greater than or equal to 1. This can ensure decoding performance of the receive end, reduce transmission resources occupied when the transmit end transmits information, and improve transmission efficiency. The methods provided in this embodiment of this application can effectively expand the selectable range of the code rate of the transmit end, and improve encoding flexibility of the transmit end. For example, the fourth threshold may be less than 0.2 for the BG1, and the fourth threshold may be less than or equal to 0.2 for the BG2.

It can be understood that, when the first sparsity is equal to the first threshold, K₁ may be equal to K₀; when the first sparsity is equal to the second threshold, the A parity columns may alternatively include the RC-1 of the BG1; or when the first sparsity is equal to the third threshold, C may not be equal to 0, and D may not be equal to 0. A specific manner when the first sparsity is equal to a temporary threshold is not limited in embodiments of this application.

It can be understood that the second threshold may be equal to the third threshold. Certainly, the second threshold may alternatively not be equal to the second threshold. This is not limited in embodiments of this application. For example, the second threshold may be less than the third threshold. For example, the second threshold may be equal to 0.05, and the third threshold may be equal to 0.1. Alternatively, the second threshold may be equal to 0.1, and the third threshold may be equal to 0.2. The second threshold and the third threshold are not enumerated in this embodiment of this application. It should be noted that for the BG1 and the BG2, the second threshold and the third threshold may be identical or different. This is not limited in embodiments of this application.

It can be understood that when the sparsity is less than or equal to the first threshold, the sparsity may be divided into two ranges, for example, a range less than or equal to the second threshold and a range greater than the second threshold; or a range less than or equal to the third threshold and a range greater than the third threshold. Alternatively, the sparsity may be divided into three ranges, for example, a range less than or equal to the second threshold, a range greater than the second threshold and less than or equal to the third threshold, and a range greater than the third threshold. Alternatively, the sparsity may be divided into four ranges or the like. This is not limited in embodiments of this application. Any method for obtaining, by the transmit end based on the first sparsity, the N₁ parity bits and the K₁ parity bits that meet the requirement of the transmission path falls within the protection scope of embodiments of this application. A quantity of ranges obtained through division or specific values for the first sparsity are not limited in embodiments of this application.

403: The transmit end sends the second bit sequence, and correspondingly the receive end receives the second bit sequence.

It can be understood that, after the second bit sequence is obtained, the transmit end actually sends a symbol sequence obtained by performing rate matching, modulation, frequency conversion, and other operations on the second bit sequence, instead of the second bit sequence. Correspondingly, the receive end receives, through a wired channel or a wireless channel, a sequence obtained through channel transmission of the symbol sequence, instead of receiving the second bit sequence. Then, the receive end can obtain the second bit sequence only after performing operations corresponding to the operations performed by the transmit end. For brevity, the descriptions of step 403 are used in this embodiment of this application, but should not be construed as any limitation on embodiments of this application. In addition, that the transmit end sends the second bit sequence is used as an example to describe FIG. 4 in the accompanying drawings, but should not be construed as any limitation on embodiments of this application.

404: The receive end determines, based on the first sparsity and the code rate, that the second bit sequence includes the K₁ information bits and the N₁ parity bits, and performs LDPC decoding on the second bit sequence, to obtain the K₀ information bits.

For example, the code rate may be dynamically or statically configured by the network device for the receive end. For example, the network device may send information including the code rate to the receive end by using radio resource control (radio resource control, RRC) signaling. For another example, the network device may send information including the code rate to the receive end by using downlink control information (downlink control information, DCI). Alternatively, the network device may deliver information including the code rate to the receive end in a broadcast manner. This is not limited in embodiments of this application. For example, the transmit end may indicate the first sparsity to the receive end by using indication information. When the code rate is unknown, the first sparsity and the code rate may be carried in a same message, or may be carried in different messages (which may be indicated to the receive end by a same communication apparatus, or may be indicated to the receive end by different communication apparatuses). This is not limited in embodiments of this application.

After obtaining the first sparsity, the receive end may determine, based on the code rate and a relationship between a sparsity range and a transmission path, the information columns and/or the parity columns used by the transmit end to perform encoding, to determine the parity bits and the information bits included in the second bit sequence. Then, the receive end may perform LDPC decoding based on the first sparsity and the code rate. For example, the receive end may obtain priori information of the K₀ information bits based on the first sparsity, and the priori information may be used to decode an initial log-likelihood ratio. For example, the decoding method may include any one of hard decision decoding, soft decision decoding, and hybrid decoding. This is not limited in embodiments of this application. For example, after obtaining the second bit sequence, the receive end may perform LDPC decoding on the second bit sequence. If the decoding is performed incorrectly or a quantity of decoding iterations does not reach a specific threshold, LDPC decoding is performed repeatedly, and the K₀ information bits are output when the decoding is performed correctly or the quantity of decoding iterations reaches the specific threshold. A condition for performing LDPC decoding again may include at least one of the following: failing to reach the quantity of decoding iterations or failing in check on a parity-check matrix. Optionally, if the receive end incorrectly performs decoding (or fails in decoding), the receive end sends retransmission indication information to the transmit end, to request the transmit end device to perform retransmission. In addition, if decoding fails, the receive end stores an initially transmitted sequence, to perform combined decoding on the initially transmitted sequence and a retransmitted sequence that is subsequently received.

In this embodiment of this application, the transmit end may perform LDPC encoding based on sparsity of the K₀ information bits (namely, the first sparsity), to obtain the K₁ information bits and the N₁ parity bits, where K₁ is less than K₀. In this case, the receive end can obtain the K₀ information bits through decoding even if the transmit end transmits only the K₁ information bits. A smaller quantity of transmitted bits occupies fewer resources. This can effectively reduce a quantity of resources occupied when the transmit end transmits information, and ensure decoding performance of the receive end.

The following describes, by using specific examples, the encoding method and the decoding method provided in embodiments of this application.

The encoding method and the decoding method described in embodiments of this application can also be understood as a joint source-channel transmission method based on an NR LDPC code. The method relates to JSCC transmission performed based on the BG1 or the BG2 of the NR LDPC code (the LDPC code shown in FIG. 3a or FIG. 3b) by using sparsity. It can be understood that the following merely describes examples of transmission paths provided in embodiments of this application. For a specific encoding method and decoding method, refer to FIG. 4. Principles in embodiments of this application may be described as follows:
Embodiments of this application provide different sparsity ranges based on analysis of theoretical decoding thresholds of a JSCC-extrinsic information transfer (extrinsic information transfer, EXIT) chart and simulation results. Then, transmission paths are finely tuned based on the BG1 or the BG2 and the different sparsity ranges, for example, whether to remove an RC-1. The transmission paths are provided based on the different sparsity ranges, including an incremental redundancy hybrid automatic repeat request (incremental redundancy-hybrid automatic repeat request, IR-HARQ) transmission combination sequence, an initial maximum code rate, and a transmission sequence of parity bits and information bits. According to the foregoing methods, the transmission paths may be obtained, and therefore the transmit end can perform LDPC encoding based on the transmission paths. For example, for p1 working ranges obtained through division, corresponding changes in decoding thresholds of an LDPC code when extended transmission is performed on extension parity bits and information bits and extended paths are different may be analyzed. It should be noted that the extended paths of the extension parity bits and the information bits shown herein may be corresponding to a code rate extension sequence and a bit transmission sequence in a HARQ transmission process. Based on analysis of the JSCC-EXIT chart and the simulation results, a transmission path of a specific quantity of information bits and parity bits is optimized for each source p1 range, to provide the different sparsity ranges and transmission paths. Correspondingly, the receive end may perform, based on sparsity, a decoding procedure corresponding to the foregoing encoding procedure performed by the transmit end. For example, a decoder performs decoding based on p1 and a known code rate.

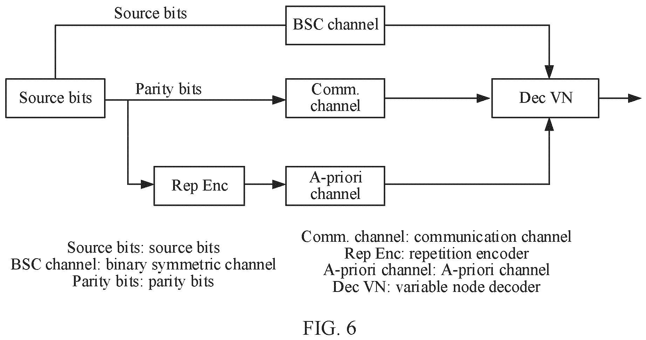

FIG. 6 is a diagram of a principle of a coding method according to an embodiment of this application. As shown in FIG. 6, parity bits (parity bits) may be obtained based on source bits (source bits) (namely, information bits). Then, the source bits may be approximately transmitted through a binary symmetric channel (binary symmetric channel, BSC), and the parity bits may be approximately transmitted through a communication channel. The parity bits are approximately transmitted through an A-priori channel (A-priori channel) by using a repetition encoder (rep-encoder). Correspondingly, decoding is performed by a variable node decoder. It should be noted that FIG. 6 can be understood as a basis of theoretical analysis. Mutual information combining the BSC and a Gaussian density function may be obtained based on the theoretical analysis, and sparsity is added to the mutual information.

In conventional JSCC-EXIT analysis, a biased source and a transmission channel approximate to a single additive white Gaussian noise (additive white Gaussian noise, AWGN) channel, and consequently accuracy of the mutual information of the JSCC-EXIT chart is low. In the JSCC-EXIT chart in embodiments of this application, the BSC channel equivalent to the biased source part and the transmission channel are separately processed, so that the mutual information in an iterative decoding process can be tracked more accurately, and a decoding threshold can be obtained more accurately. In other words, during theoretical analysis, the source bits and the parity bits are separately analyzed, whereas during LDPC encoding, the source bits and the parity bits are jointly processed. A decoding threshold of a protograph can be understood as a minimum SNR or Eb/Nₒᵢₛₑ needed for successfully decoding by using an LDPC code ensemble corresponding to the protograph when a code length is infinite. In other words, if the decoding threshold is smaller, the LDPC code ensemble corresponding to the protograph is closer to a channel capacity (which may also be referred to as better performance) when the code length approaches infinity. Eb represents a transmitted wanted signal, and Nₒᵢₛₑ represents transmission noise. It can be understood that in the JSCC-EXIT analysis, a calculated input of the mutual information includes a mean value of sparsity p1 of a source and a log-likelihood ratio (log-likelihood ratio, LLR) of bits transmitted on a channel, that is, the mutual information depends on both the sparsity of the source and a signal-to-noise ratio of the channel.

Based on analysis and calculation of decoding thresholds of the NR BG1 and the NR BG2 in the JSCC-EXIT chart, embodiments of this application provide the encoding method and the decoding method shown in FIG. 4. Specific methods may be further described as follows.

In the encoding method provided in embodiments of this application, a specific quantity of information bits may be punctured (that is, the transmit end does not transmit the punctured information bits). Puncturing the specific quantity of information bits herein can be understood as a method for reserving the K₁ information bits and the N₁ parity bits. Correspondingly, the receive end may recover the K₀ information bits by using known p1 and transmitted bits.

The following describes, separately by using the BG1 and the BG2, the methods provided in embodiments of this application.

The joint source-channel transmission scheme based on the BG1 of the NR LDPC code is first described.

Based on the BG1 of the NR LDPC code shown in FIG. 5a, embodiments of this application provide a decoding threshold of an LDPC code obtained through extension of each column in a protograph corresponding to information bits and extension parity bits, and a transmission path is determined based on the calculated decoding threshold. It can be understood that the information bits and the extension parity bits shown herein are not obtained in an exhaustive manner. Instead, a range is determined by using simulation results (that is, three-dimensional simulation results including the parity bits, the information bits, and the decoding threshold), and then the information bits and the extension parity bits are determined based on the decoding threshold. To be specific, in embodiments of this application, a relationship between a quantity of extension parity columns in the BG1, a quantity of extension information columns in the BG1, and a decoding threshold may be obtained (for example, may be displayed by using a three-dimensional graph) through theoretical analysis shown in FIG. 6. Further, the relationship may further include simulation results when the extension parity columns in the BG1 include the RC-1 and do not include the RC-1. Further, the decoding threshold may include a simulation result of an absolute value of the decoding threshold, and a simulation result of a distance between the absolute value of the decoding threshold and a channel capacity at a corresponding code rate. The three-dimensional simulation graph is not described in embodiments of this application again.

All parity bits (denoted by a small black square in FIG. 5a) corresponding to the four core parity columns included in the 4×4 square matrix of a parity part of a kernel matrix in a base matrix need to be transmitted. The transmission path may be extended based on the four core parity columns, and both the extension parity bit part (that is, the part corresponding to Idx_ext shown in FIG. 5a, starting from left to right) and the information (or source) bit part (that is, the part corresponding to Idx_inf in FIG. 5b, starting from right to left) are extended. In addition, a row and a column, namely, the RC-1, corresponding to 1^{st} extension of the extension parity bits may be connected to first two punctured columns of the matrix. This connection mode is quite effective for a channel coding mode. However, in embodiments of this application, during initial transmission, columns corresponding to most information bits are punctured and not transmitted, and consequently the extension columns corresponding to the RC-1 greatly affect performance that is present when a source is sparse. In view of this, in embodiments of this application, whether an RC-1 is removed during 1^{st} extension for each p1 range is determined through comparison. It can be understood that the descriptions of the core parity columns, the extension parity columns, and the like herein are also applicable to the following joint source-channel transmission scheme based on the BG2 of the NR LDPC code.

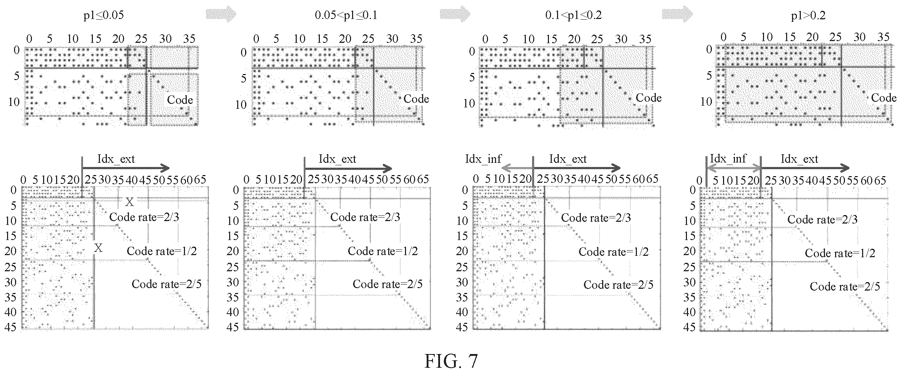

For example, FIG. 7 is a diagram of transmission paths based on different sparsity ranges of a BG1 according to an embodiment of this application. As shown in FIG. 7, sparsity may be divided into four ranges, and a transmission path corresponding to each range may be at least one of the following:
Implementation 1: p1≤0.05, a row-column RC-1 is punctured (X shown on a leftmost side in FIG. 7 indicates that the RC-1 is not transmitted), only parity bits are transmitted, and none of information bits are transmitted. For example, an initial code rate is R=2.
Implementation 2: 0.05<p1≤0.1, a row-column RC-1 is reserved, and only parity bits are transmitted. For example, an initial code rate is R=1.38.
Implementation 3: 0.1<p1≤0.2, a row-column RC-1 is reserved, and parity bits and some information bits are transmitted. For example, an initial code rate is R=1 or R=0.92.
Implementation 4: p1>0.2, and a transmission mode falls back to a channel coding (channel coding, CC) mode, that is, all information bits and core parity bits need to be transmitted, and extension parity bits are gradually transmitted.

It should be noted that the foregoing four ranges are merely examples, and should not be construed as any limitation on embodiments of this application. A relationship between sparsity and a quantity of information bits and a relationship between sparsity and parity bits fall within the protection scope of embodiments of this application. For descriptions of the implementations, refer to the following descriptions.

The following specifically describes a transmission path optimization manner for each sparsity p1 range. It should be noted that, for each sparsity range, transmission path optimization is performed by using a maximum value of the range p1 as a reference, because a transmission scheme designed for large p1 corresponding to a transmission path in embodiments of this application is downward compatible with that designed for small p1 (for example, a transmission path when p1=0.2 is applicable to a transmission path when p=0.05). For different sparsity ranges, a code rate loss during reliable transmission is further reduced in embodiments of this application.

The descriptions of the foregoing implementation 1 to implementation 4 are as follows.

### Implementation 1:

For source sparsity p1=0.05, JSCC-EXIT decoding thresholds of transmission paths when the NR BG1 includes the RC-1 and the RC-1 is removed from the NR BG1 may be obtained through simulation. In this embodiment of this application, when p1=0.05, the transmit end needs to transmit only extension parity bits to ensure decoding performance of the receive end, and ensure a desirable decoding threshold.

When p1=0.05, regardless of the transmission path including the RC-1 or the transmission path without the RC-1, a desirable decoding threshold can be reached by transmitting only parity bits. Optionally, a lower decoding threshold can be reached at a same extended code rate for the transmission path without the RC-1. Therefore, the transmission path described in this embodiment of this application is a transmission path determined when the RC-1 is removed. It should be noted that, when a region of a large quantity of parity bits is extended, there is a large distance between a decoding threshold and a corresponding capacity. This is because a parity-check matrix of the NR LDPC is originally designed for channel coding.

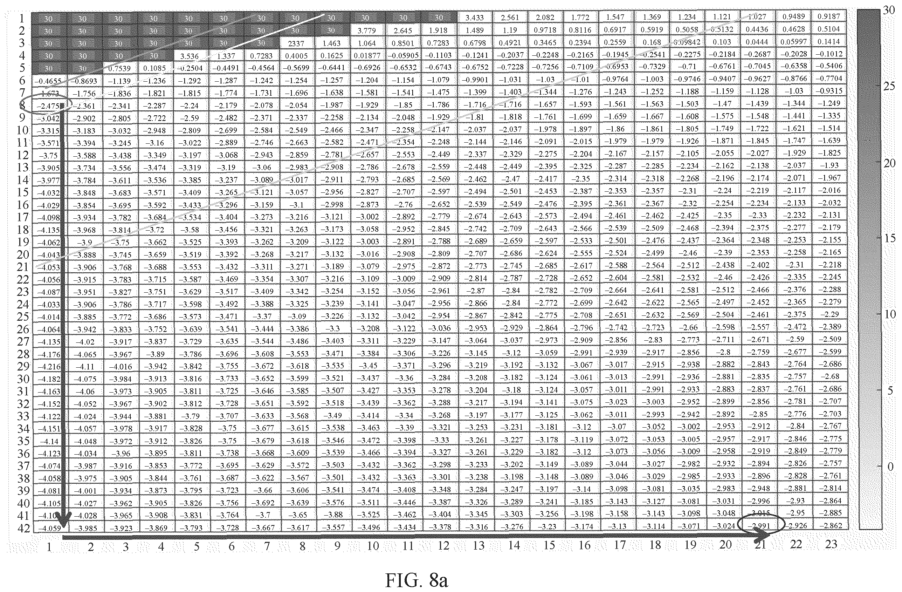

FIG. 8a is a diagram of a JSCC transmission path based on an NR BG1 when p1=0.05 according to an embodiment of this application. As shown in FIG. 8a, a horizontal coordinate can be understood as an information column, a vertical coordinate can be understood as an extension parity column, and oblique lines can be understood as same code rates. For example, the following uses idx_ext to represent a quantity of extension parity columns, and uses idx_inf to represent a quantity of information columns. In this case, the oblique lines shown in FIG. 8a can be understood as different decoding thresholds when idx_ext+idx_inf has a same value. Same sums of quantities of columns (that is, sums of idx_ext+idx_inf) are corresponding to a same code rate. Therefore, based on the diagram shown in FIG. 8a, the transmission path provided in this embodiment of this application may be equivalent to different combinations of idx_ext and idx_inf when a code rate changes. It can be understood that a numeral 1 shown in FIG. 8a indicates that transmission is not needed, that is, the numeral 1 does not represent an information column or an extension parity column. When p1 is less than or equal to 0.05, because an RC-1 may not be transmitted, the vertical coordinate in FIG. 8a shows a total of 41 extension parity columns.

It should be noted that 30 shown in FIG. 8a can be understood as an extended path when a decoding threshold approaches infinity, and indicates that the JSCC cannot implement error-free transmission in these combinations of idx_ext+idx _inf. In this case, when p1=0.05, an available initial extended code rate may be determined as a start point of the transmission path. For example, the initial code rate R may satisfy R=22/(4+7)=2.0, that is, an upper left circle shown in FIG. 8a may be used as a start. Herein, 22 represents a total quantity of information columns, 4 represents a quantity of core parity columns, and 7 represents a quantity of extension parity columns (excluding the RC-1). For example, a code rate R obtained through extension of all parity columns may satisfy: R=22/(4+41+20)=0.34, that is, a lower right circle shown in FIG. 8a. Herein, 22 represents a total quantity of information columns, 4 represents a quantity of core parity columns, 41 represents a quantity of extension parity columns (excluding the RC-1), and 20 represents a quantity of information columns. Certainly, a lower code rate may be alternatively obtained by repeatedly extending transmitted columns.

In this case, a transmission path corresponding to a horizontal line part and a transmission path corresponding to a vertical line part shown in FIG. 8a can be understood as the transmission path provided in this embodiment of this application. In addition, when p1=0.05, the RC-1 is removed, and better performance can be obtained. In other words, when p1=0.05, the transmit end may transmit only parity bits but not information bits during initial transmission. The parity bits transmitted by the transmit end may be obtained based on A parity columns and an expansion factor. A quantity of the A parity columns may be greater than or equal to 11 and less than or equal to 45, and the A parity columns do not include the RC-1. In an example, when the transmit end performs initial transmission, the parity bits may be obtained based on the 11 to 46 parity columns. After transmission of the parity bits is completed, the transmit end may transmit the information bits. The information bits may be obtained based on C information columns and the expansion factor. A quantity of the C information columns may be greater than or equal to 1 and less than or equal to 20. It can be understood that, how the transmit end performs retransmission is not limited in this embodiment of this application. For example, during retransmission, the transmit end may further transmit parity bits and/or information bits that have not been transmitted. Alternatively, during retransmission, in addition to transmitting initial parity bits, the transmit end may further transmit parity bits or information bits that have not been transmitted, and a HARQ may be flexibly changed. It can be understood that, for example, the transmit end initially may start transmission from the circle location on the upper left in FIG. 8a based on the given initial code rate, and first transmit extension parity bits and finally transmit remaining information bits, or finally transmit extension parity bits, information bits, and the like. For example, the transmit end may alternatively start transmission at any location in the path shown in FIG. 8a. This is not limited in embodiments of this application. The descriptions of initial transmission and retransmission herein are also applicable to the following implementations. Details are not described in the following again.

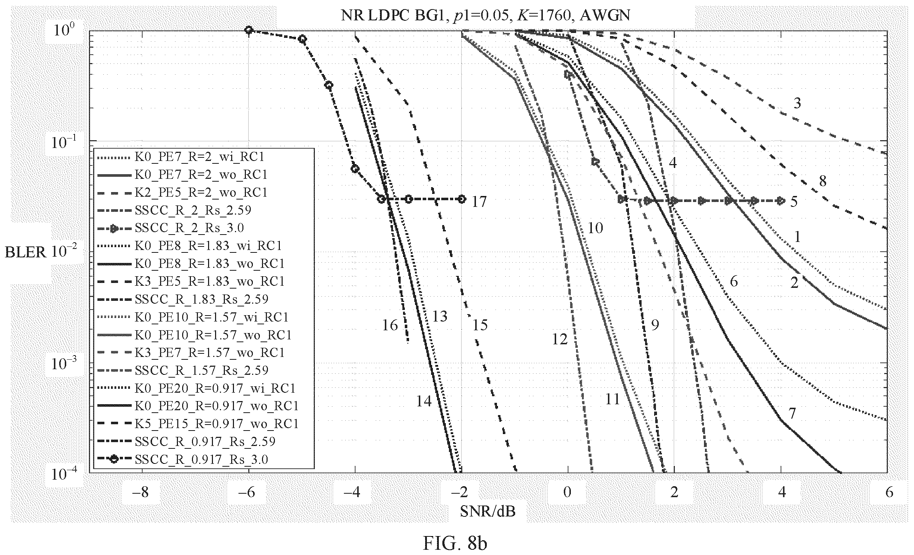

FIG. 8b is a diagram of simulation results according to an embodiment of this application. In FIG. 8b, a horizontal coordinate represents an SNR measured in dB, and a vertical coordinate represents a block error rate (block error rate, BLER). In addition, in FIG. 8b, X in KX represents a quantity of base-matrix information columns for extended transmission, and Y in PEY represents a quantity of base-matrix extension parity columns for extended transmission. It can be understood that the four core parity columns may be transmitted by default, and are not included in the quantity Y. wi_RC-1 indicates that an RC-1 is included in extended transmission, and wo_RC-1 indicates that the RC-1 is not included in extended transmission. As shown in FIG. 8b, X includes 0, 2, 3, and 5, and Y includes 7, 5, 8, 10, 20, and 15. For example, K0_PE7_R=2_wi_RC_1 indicates a simulation result when an information column is not included, seven parity columns are included, and the RC-1 is included in extended transmission; K0_PE7_R=2_wo_RC_1 indicates a simulation result when an information column is not included, seven parity columns are included, and the RC-1 is not included in extended transmission; and K2_PE5_R=2_wo_RC_1 indicates a simulation result when two information columns and five parity columns are included and the RC-1 is not included in extended transmission. Details are not enumerated herein. Values (for example, 2, 1.83, 1.57, and 0.917) before wi or wo in FIG. 8b may represent initial transmission code rates or initial code rates.

In the simulation results shown in FIG. 8b, information bits (which may also be referred to as source bits) are 1760 bits (K=1760 is used as an example in FIG. 8b, and with reference to the foregoing descriptions, 1760 herein can also be understood as K₀). These information bits are generated according to Bernoulli (Bernoulli) distribution based on p1=0.05. Generally, decoding performance comparison is meaningful only when code rates are the same. Therefore, it can be learned from FIG. 8b that performance is better if parity bits corresponding to the RC-1 are not transmitted. In FIG. 8b, SSCC is a separate source-channel coding scheme, a source coding part uses arithmetic coding, and a channel coding part uses a standard NR LDPC code. It can be learned that the SSCC scheme highly depends on code rate allocation of source coding and channel coding, but the code rate allocation issue does not need to be considered in the JSCC scheme described in embodiments of this application. In addition, compared with the SSCC, the JSCC scheme described in embodiments of this application has lower complexity because the first bit sequence may be a compressed sequence before LDPC encoding. It can be understood that, for ease of differentiation, a relationship between descriptions on a lower left side and curves in FIG. 8b may be shown in FIG. 8b. A sequence of the descriptions on the lower left side is sequentially corresponding to an ascending order marked for the curves. The descriptions are also applicable to the following descriptions.

It can be understood that p1=0.05 shown above is merely an example. For descriptions of p1 less than 0.05, refer to the implementation 1. Details are not described in this embodiment of this application again.

### Implementation 2:

For similar content, refer to the implementation 1. For source sparsity p1=0.10, a three-dimensional simulation graph that includes a quantity of extension parity columns in the BG1, a quantity of extension information columns in the BG1, and a decoding threshold can still be obtained. For descriptions of the simulation graph, refer to the implementation 1. Details are not described in this embodiment of this application again. In this embodiment of this application, when p1=0.10, regardless of the transmission path including the RC-1 or the transmission path without the RC-1, a desirable decoding threshold can be reached by transmitting only parity bits. Optionally, a lower decoding threshold can be reached at a same extended code rate for the transmission path including the RC-1. Therefore, the transmission path described in this embodiment of this application is determined when the RC-1 is included.

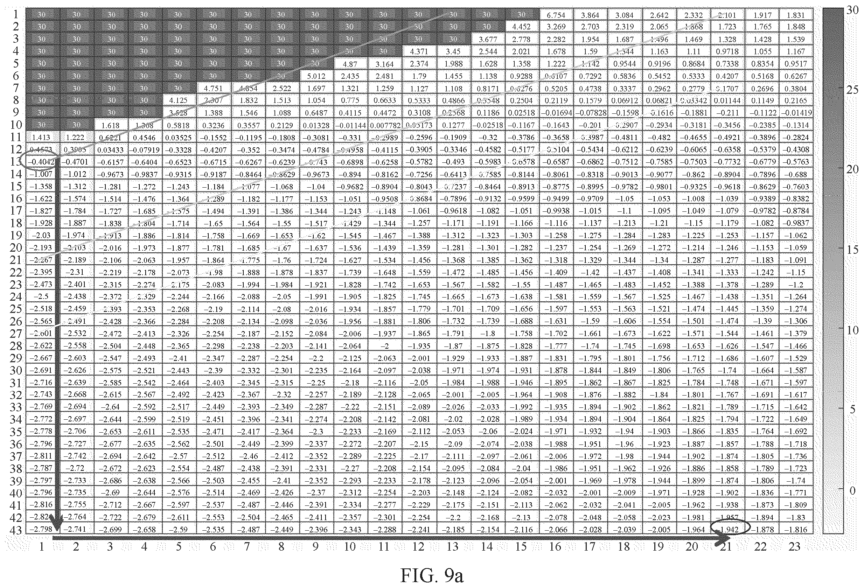

FIG. 9a is a diagram of a JSCC transmission path based on an NR BG1 when p1=0.1 according to an embodiment of this application. Because the transmission path includes an RC-1, a vertical coordinate shown in FIG. 9a shows a total of 42 extension parity columns. For descriptions of horizontal and vertical coordinates, oblique lines, and the like in FIG. 9a, refer to FIG. 8a. Details are not described herein again.

In this case, in this embodiment of this application, when p1=0.1, an available initial extended code rate may be determined as a start point of the transmission path. For example, the initial code rate R=22/(4+12)=1.38 may be used as a start, that is, an upper left circle shown in FIG. 9a may be used as a start point. 22 represents a total quantity of information columns, 4 represents a quantity of core parity columns, and 12 represents a quantity of extension parity columns. For example, a code rate R obtained through extension of all parity columns is R=22/(4+42+20)=0.33 (certainly, a lower code rate may be alternatively obtained by repeatedly extending transmitted columns), that is, a lower right circle shown in FIG. 9a. 22 represents a quantity of information columns, 4 represents a quantity of core parity columns, 42 represents a quantity of extension parity columns, and 20 represents a quantity of information columns corresponding to transmitted information bits (for example, the K₁ information bits shown above).

A transmission path corresponding to a horizontal line part and a transmission path corresponding to a vertical line part shown in FIG. 9a can be understood as the transmission path provided in this embodiment of this application. In addition, when p1=0.10, the RC-1 is included, and better performance can be obtained by preferentially transmitting extension parity bits. In other words, when p1=0.1, the transmit end may transmit only parity bits but not information bits during initial transmission. The parity bits transmitted by the transmit end may be obtained based on A parity columns and an expansion factor. A quantity of the A parity columns may be greater than or equal to 16 and less than or equal to 46. In an example, when the transmit end performs initial transmission, the parity bits may be obtained based on the 16 to 46 parity columns. After transmission of the parity bits is completed, the transmit end may transmit the information bits. The information bits may be obtained based on C information columns and the expansion factor. A quantity of the C information columns may be greater than or equal to 1 and less than or equal to 20. It can be understood that, how the transmit end performs retransmission is not limited in this embodiment of this application. For descriptions of the transmission path, refer to the implementation 1. Details are not described herein again.

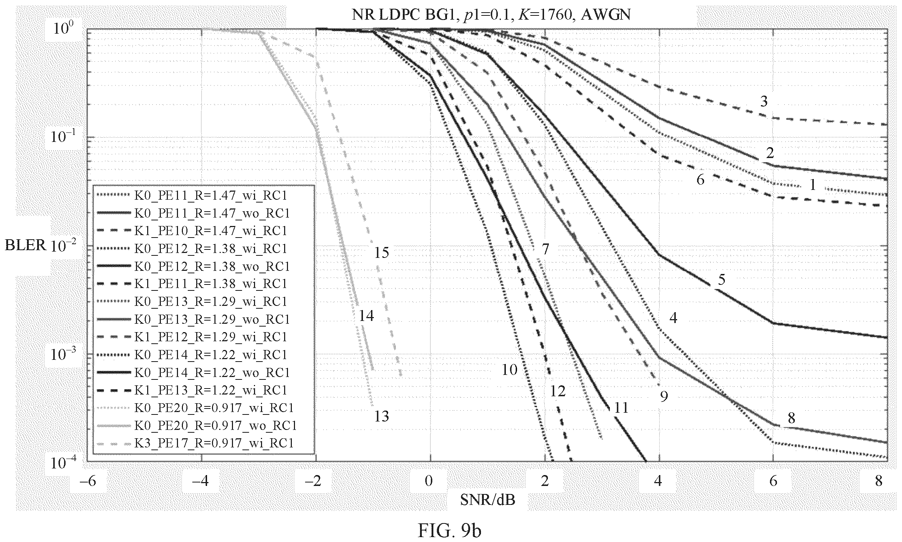

FIG. 9b is a diagram of simulation results according to an embodiment of this application. For descriptions of horizontal and vertical coordinates, KX, PEY, and the like shown in FIG. 9b, refer to FIG. 8b. Details are not described herein again. In the simulation results shown in FIG. 9b, information bits are 1760 bits. These information bits are generated according to Bernoulli distribution based on p1=0.10. The optimized transmission path extended at an optimal rate in this embodiment of this application can achieve optimal BLER performance, and there is a loss in performance of other tested paths deviated from the optimal path.

### Implementation 3:

For similar content, refer to the implementation 1 or the implementation 2. For source sparsity p1=0.20, a three-dimensional simulation graph that includes a quantity of extension parity columns in the BG1, a quantity of extension information columns in the BG1, and a decoding threshold can be obtained. For descriptions of the simulation graph, refer to the implementation 1. Details are not described in this embodiment of this application again. When p1=0.20, for a transmission scheme in which the RC-1 is included or removed, a desirable decoding threshold cannot be reached by transmitting only parity bits, and a specific quantity of information bits need to be transmitted.

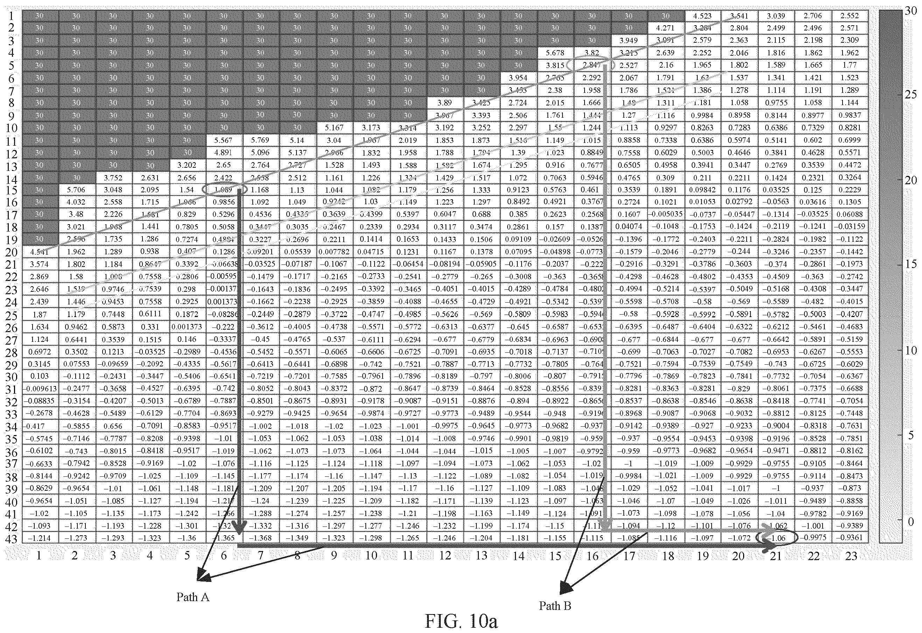

FIG. 10a is a diagram of JSCC transmission paths based on an NR BG1 when p1=0.2 according to an embodiment of this application. For descriptions of horizontal and vertical coordinates, oblique lines, and the like in FIG. 10a, refer to FIG. 8a and FIG. 9a. Details are not described herein again.

In this case, in this embodiment of this application, when p1=0.20, an available initial extended code rate may be determined as a start point of the transmission path. As shown in FIG. 10a, this embodiment of this application provides two extended transmission paths, for example, a path A and a path B, for different reliability requirements. Decoding thresholds corresponding to the path A and the path B change sharply (for example, p1 is less than or equal to 0.1) when a source is not particularly sparse. In this case, the transmit end may select the path A and the path B based on different reliability. In addition, the decoding thresholds of the two paths herein are better than those of other LDPC encoding.

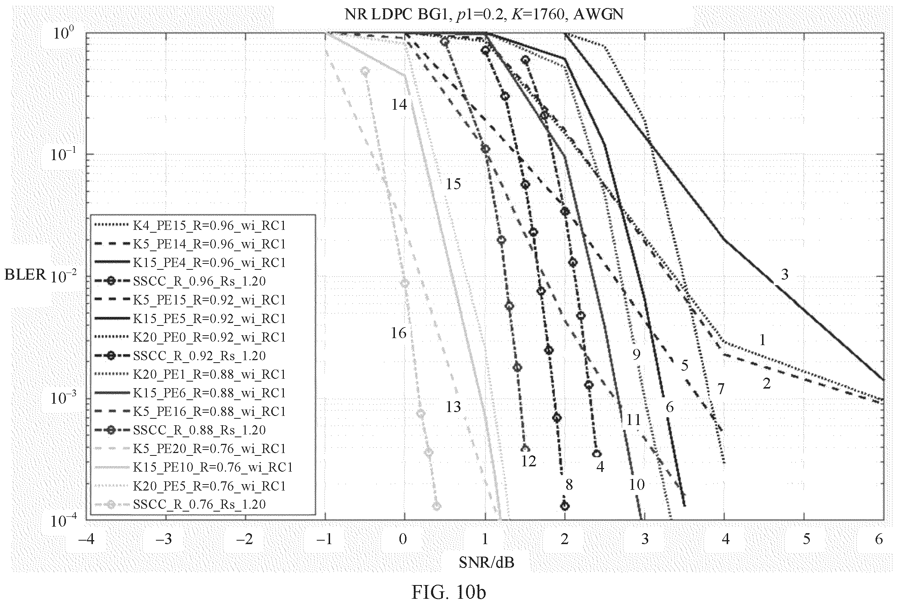

FIG. 10b is a diagram of simulation results according to an embodiment of this application. Information bits are 1760 bits. These information bits are generated according to Bernoulli distribution based on p1=0.20. If reliability needed for transmission in a system is approximately a BLER being 10⁻², the path A may be a transmission path, and an initial code rate is R=22/(4+5+14)=0.96. 22 represents a total quantity of information columns, 4 represents a quantity of core parity columns, 5 represents a quantity of information columns corresponding to transmitted information bits, and 14 represents a quantity of extension parity columns. If reliability needed for transmission in a system is approximately a BLER being 10⁻⁴, the path B may be a transmission path, and an initial code rate is R=22/(4+15+4)=0.96. 22 represents a total quantity of information columns, 4 represents a quantity of core parity columns, 15 represents a quantity of information columns corresponding to transmitted information bits, and 4 represents a quantity of extension parity columns. In addition, the optimized transmission path in this embodiment of this application can achieve optimal BLER performance, and there is a loss in performance of other tested paths deviated from the optimal path.

It can be understood that the initial code rates of the path A and the path B are the same, so that when performing LDPC decoding, the transmit end can conveniently select the path A or the path B based on the BLER without considering a code rate difference.

In this embodiment of this application, when p1=0.2, the transmit end may transmit information bits corresponding to some information columns and parity bits during initial transmission. The parity bits transmitted by the transmit end may be obtained based on A parity columns and an expansion factor. A quantity of the A parity columns may be greater than or equal to 18 and less than or equal to 46 (the path A shown in FIG. 10a), or a quantity of the A parity columns may be greater than or equal to 8 and less than or equal to 46 (the path B shown in FIG. 10b). The information bits transmitted by the transmit end may be obtained based on C information columns and the expansion factor. A quantity of the C information columns may be greater than or equal to 5 and less than or equal to 20 (the path A shown in FIG. 10a), or a quantity of the C information columns may be greater than or equal to 15 and less than or equal to 20 (the path B shown in FIG. 10b). It can be understood that, how the transmit end performs retransmission is not limited in this embodiment of this application. For descriptions of the transmission path, refer to the implementation 1, the implementation 2, and the like. Details are not described herein again.

### Implementation 4:

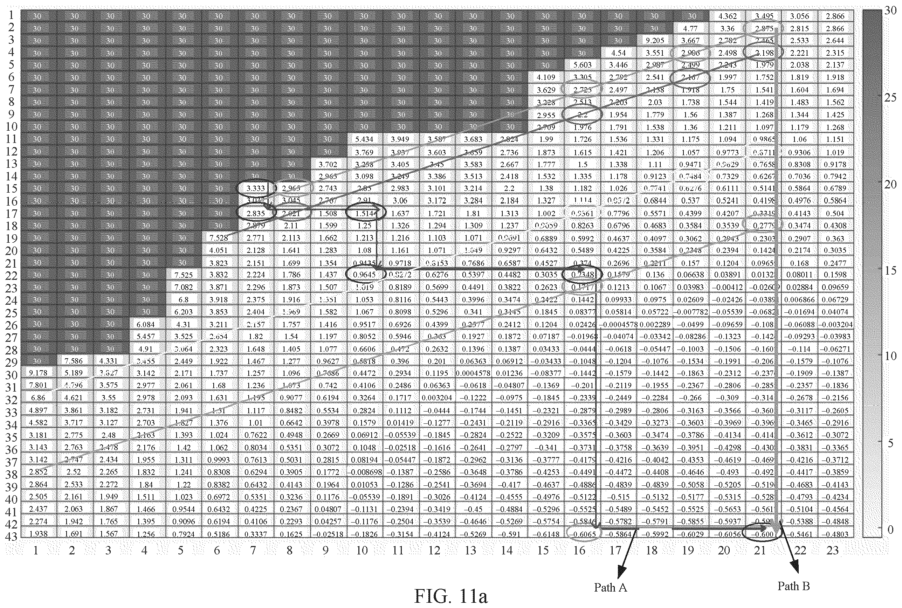

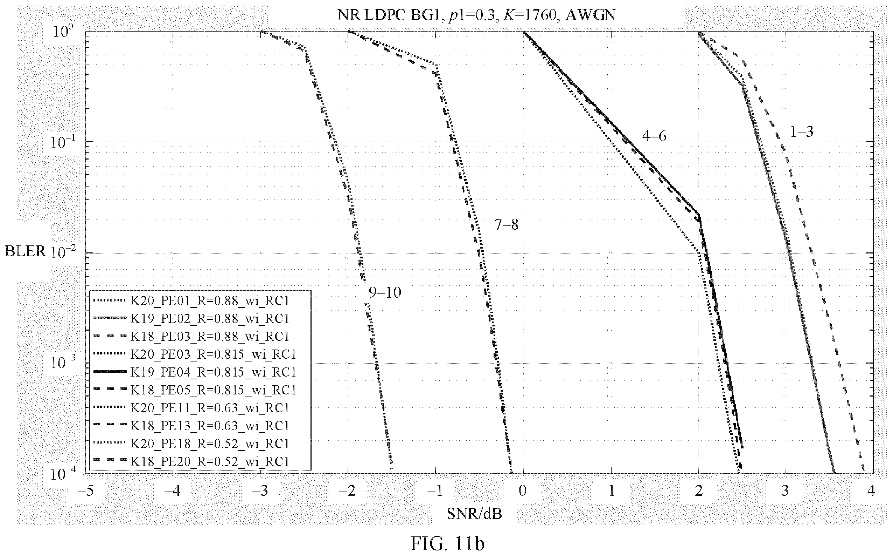

For similar content, refer to the implementation 1 to the implementation 3. In this embodiment of this application, when source sparsity p1=0.30, for a transmission scheme in which the RC-1 is included or removed, a desirable decoding threshold cannot be reached by transmitting only parity bits, and a specific quantity of information bits need to be transmitted to reach a desirable decoding threshold (a path A shown in FIG. 11a). FIG. 11a shows two paths, where a path (path B) corresponding to a vertical line on the right can be understood as a CC mode. It can be learned from FIG. 11a that decoding thresholds corresponding to the two paths change sharply when a source is not particularly sparse, and the decoding thresholds of the two paths at a same code rate slightly differ from each other. Further, FIG. 11b is a diagram of simulation results when information bits are 1760 bits according to an embodiment of this application. For a case in which p1=0.3, there is a slight performance difference between the path A and the path B. In this case, when p1>0.2, a transmission mode may fall back to a channel coding mode.

The joint source-channel transmission scheme based on the BG2 of the NR LDPC code is then described.

Based on the BG2 of the NR LDPC code shown in FIG. 5b, embodiments of this application also provide a decoding threshold of an LDPC code obtained through extension of each column in a protograph corresponding to information bits and extension parity bits, and a transmission path is determined based on the calculated decoding threshold. For related descriptions of the BG2 of the NR LDPC code, refer to the descriptions of the BG1. Details are not described in this embodiment of this application again.

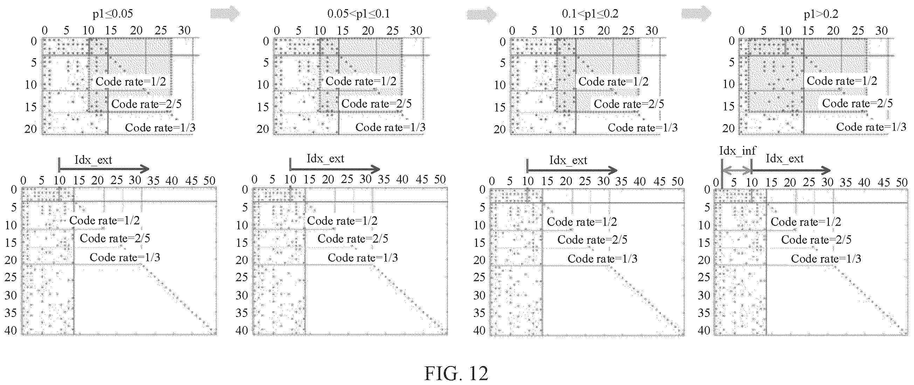

In this embodiment of this application, whether an RC-1 is removed during 1^{st} extension for each sparsity range is determined through comparison, and it is found that better performance can be achieved by reserving the RC-1 for BG2-based LDPC encoding. For example, FIG. 12 is a diagram of transmission paths based on different sparsity ranges of a BG2 of an NR LDPC code according to an embodiment of this application. To be consistent with the ranges shown in FIG. 7, sparsity is still divided into four ranges (merely used as an example) in this embodiment of this application, and a transmission path corresponding to each range may be at least one of the following:
Implementation 5: p1≤0.05, a row-column RC-1 is reserved, only parity bits are transmitted, and none of information bits are transmitted. For example, an initial code rate is R=2 or R=1.67.
Implementation 6: 0.05<p1≤0.1, a row-column RC-1 is reserved, only parity bits are transmitted, and none of information bits are transmitted. For example, an initial code rate is R=1.43.
Implementation 7: 0.1<p1≤0.2, a row-column RC-1 is reserved, only parity bits are transmitted, and none of information bits are transmitted. For example, an initial code rate is R=1.
Implementation 8: p1>0.2, and a transmission mode falls back to a channel coding mode, that is, all information bits and core parity bits need to be transmitted, and extension parity bits are gradually transmitted.

The following specifically describes a transmission path optimization manner for each sparsity p1 range. The descriptions of the foregoing implementation 5 to implementation 8 are as follows.

### Implementation 5:

For source sparsity p1=0.05, JSCC-EXIT decoding thresholds of transmission paths when the NR BG2 includes the RC-1 and the RC-1 is removed from the NR BG2 may be obtained through simulation. In this embodiment of this application, when p1=0.05, for a transmission scheme in which the RC-1 is included or removed, a desirable decoding threshold can be reached by transmitting only parity bits. Optionally, with overall consideration, a lower decoding threshold can be reached at a same extended code rate for the transmission path including the RC-1. Therefore, the following uses an example in which the RC-1 is included to determine a transmission path.

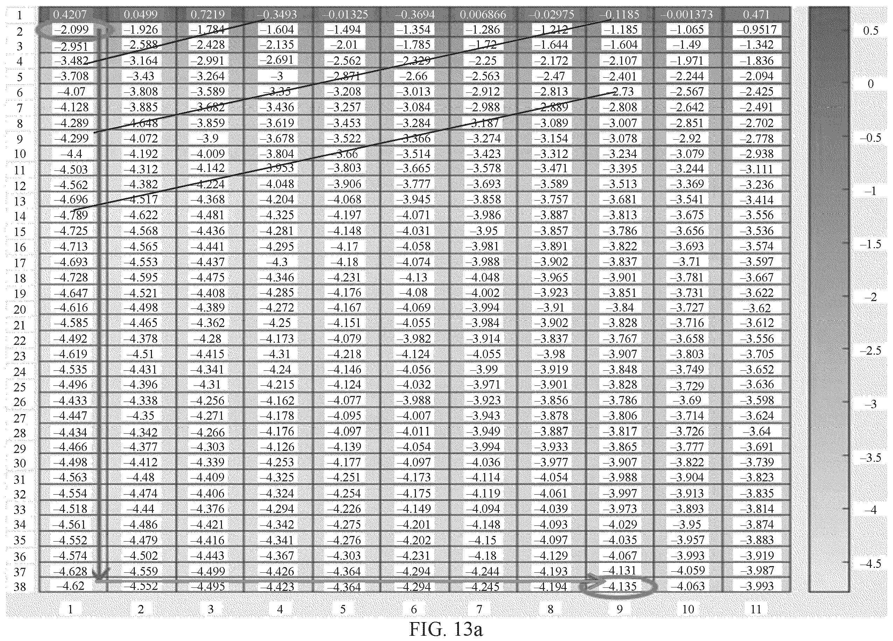

FIG. 13a is a diagram of a JSCC transmission path based on an NR BG2 when p1=0.05 according to an embodiment of this application. For descriptions of horizontal and vertical coordinates, oblique lines, and the like in FIG. 13a, refer to the foregoing implementation 1 to implementation 4. Details are not described herein again.

In this case, when p1=0.05, an available initial extended code rate is determined as a start point of the transmission path. For example, the initial code rate R may satisfy R=10/(4+1)=2.0, that is, an upper left circle shown in FIG. 13a may be used as a start point. 10 represents a total quantity of information columns, 4 represents a quantity of core parity columns, and 1 represents a quantity of extension parity columns. For example, a code rate R obtained through extension of all parity columns may satisfy: R=10/(4+37+8)=0.2, that is, a lower right circle shown in FIG. 13a. 10 represents a total quantity of information columns, 4 represents a quantity of core parity columns, 37 represents a quantity of extension parity columns, and 8 represents a quantity of extension parity columns corresponding to the K₁ information bits. Certainly, a lower code rate may be alternatively obtained by repeatedly extending transmitted columns. In this case, based on the path shown in FIG. 13a, when p1=0.05, the RC-1 is included, and better performance can be obtained by preferentially transmitting extension parity bits. In other words, when p1=0.05, the transmit end may transmit only parity bits but not information bits during initial transmission. A quantity of the parity bits may be obtained based on B parity columns and an expansion factor. A quantity of the B parity columns may be greater than or equal to 5 and less than or equal to 41. After transmission of the parity bits is completed, the transmit end may transmit the information bits. The information bits may be obtained based on D information columns and the expansion factor. A quantity of the D information columns may be greater than or equal to 1 and less than or equal to 8. It can be understood that, how the transmit end performs retransmission is not limited in this embodiment of this application. For descriptions of the transmission path, refer to the implementation 1. Details are not described herein again.

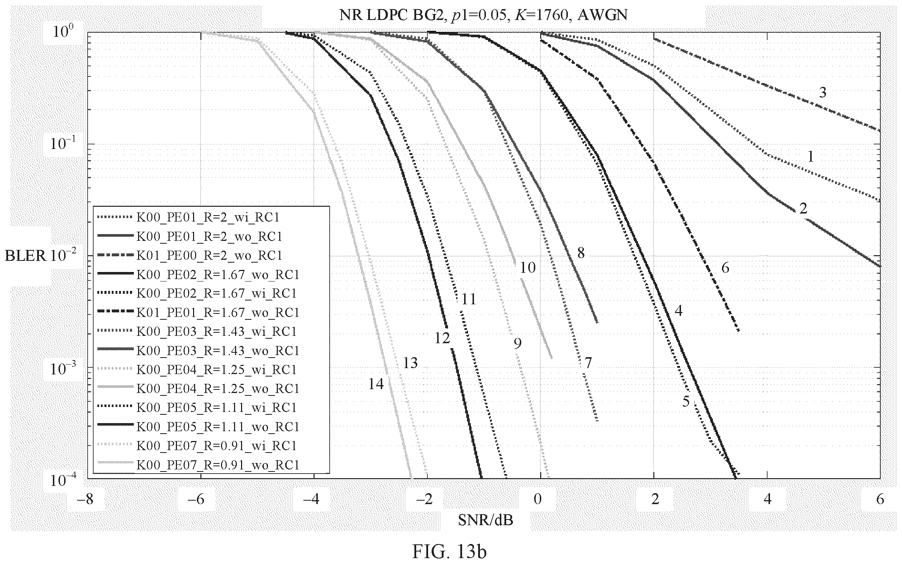

FIG. 13b is a diagram of simulation results according to an embodiment of this application. For descriptions of horizontal and vertical coordinates in FIG. 13b, refer to FIG. 8b. Details are not described herein again. It can be understood that, a relationship between descriptions on a lower left side and curves in FIG. 13b may be shown in FIG. 13b. A sequence of the descriptions on the lower left side is sequentially corresponding to an ascending order marked for the curves. In the simulation graph shown in FIG. 13b, information bits are 1760 bits. These information bits are generated according to Bernoulli distribution based on p1=0.05. Based on FIG. 13b, when p1=0.05, an extended transmission scheme in which the RC-1 is included has better performance at various code rates. In addition, the transmission path provided in this embodiment of this application achieves desirable BLER performance, and there is a loss in performance of other tested paths deviated from the optimal path.

### Implementation 6:

For similar content, refer to the implementation 5. For source sparsity p1=0.10, a three-dimensional simulation graph that includes a quantity of extension parity columns in the BG2, a quantity of extension information columns in the BG2, and a decoding threshold can be obtained. In this embodiment of this application, when source sparsity p1=0.10, for a transmission scheme in which the RC-1 is included or removed, an optimal decoding threshold can be reached by transmitting only parity bits. Optionally, a lower decoding threshold can be reached at a same extended code rate for the scheme in which the RC-1 is included. Therefore, the following uses an example in which the RC-1 is included to describe a transmission path.

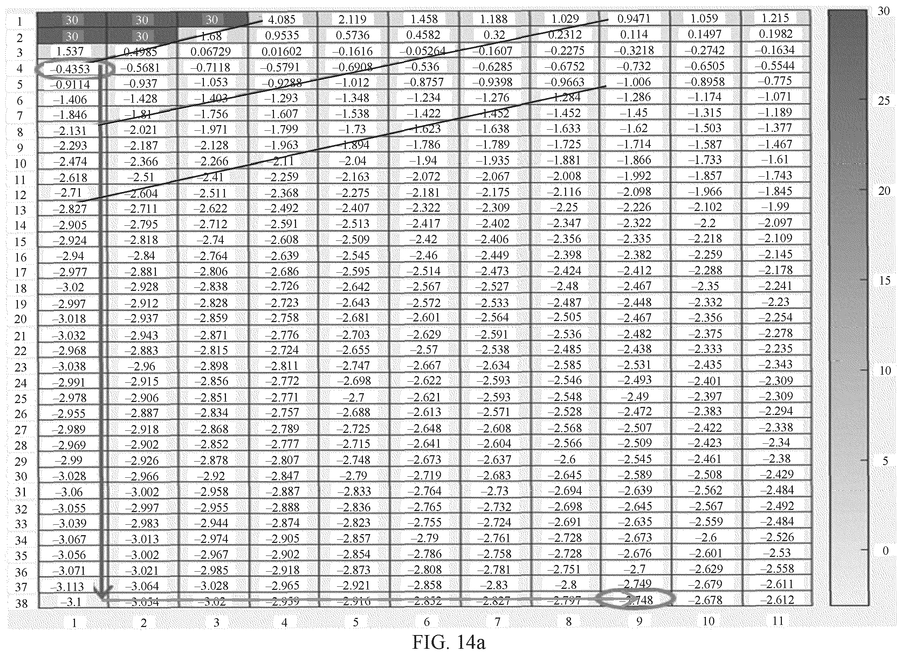

FIG. 14a is a diagram of a JSCC transmission path based on an NR BG2 when p1=0.1 according to an embodiment of this application. For descriptions of horizontal and vertical coordinates, oblique lines, and the like in FIG. 14a, refer to FIG. 8a. Details are not described herein again.

In this case, in this embodiment of this application, when p1=0.10, an available initial extended code rate may be determined as a start point of the transmission path. For example, the initial code rate R=10/(4+3)=1.43 is used as a start. 10 represents a total quantity of information columns, 4 represents a quantity of core parity columns, and 3 represents a quantity of extension parity columns. A code rate R obtained through extension of all parity columns is R=10/(4+37+8)=0.2 (or a lower code rate is obtained by repeatedly extending transmitted columns). 10 represents a total quantity of information columns, 4 represents a quantity of core parity columns, 37 represents a quantity of extension parity columns, and 8 represents a quantity of information columns corresponding to the K₁ information bits. When p1=0.10, the RC-1 is included, and better performance can be obtained by preferentially transmitting extension parity bits. In other words, when p1=0.1, the transmit end may transmit only parity bits but not information bits during initial transmission. The parity bits transmitted by the transmit end may be obtained based on B parity columns and an expansion factor. A quantity of the B parity columns may be greater than or equal to 7 and less than or equal to 41. In an example, when the transmit end performs initial transmission, the parity bits may be obtained based on the 7 to 41 parity columns. After transmission of the parity bits is completed, the transmit end may transmit the information bits. The information bits may be obtained based on D information columns and the expansion factor. A quantity of the D information columns may be greater than or equal to 1 and less than or equal to 8. It can be understood that, how the transmit end performs retransmission is not limited in this embodiment of this application. For descriptions of the transmission path, refer to FIG. 8a and the like. Details are not described herein again.

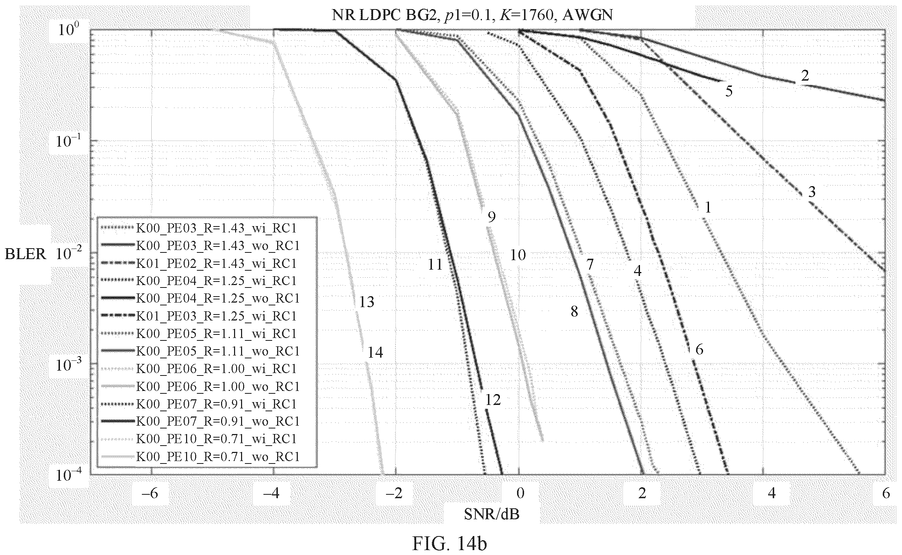

FIG. 14b is a diagram of simulation results according to an embodiment of this application. For descriptions of horizontal and vertical coordinates and the like in FIG. 14b, refer to FIG. 8b. Details are not described herein again. In the simulation results shown in FIG. 14b, information bits are 1760 bits. These information bits are generated according to Bernoulli distribution based on p1=0.10. In this case, when p1=0.1, an extended transmission scheme in which the RC-1 is included has better performance at various code rates. In addition, the optimized transmission path in this embodiment of this application can achieve desirable BLER performance, and there is a loss in performance of other tested paths deviated from the optimal path.

### Implementation 7:

For similar content, refer to the implementation 5 and the implementation 6. In this embodiment of this application, when source sparsity p1=0.20, for a transmission scheme in which the RC-1 is included or removed, a desirable decoding threshold can be reached by transmitting only parity bits. Optionally, a lower decoding threshold can be reached at a same extended code rate for the scheme in which the RC-1 is included. Therefore, the following uses an example in which the RC-1 is included to determine a transmission path.

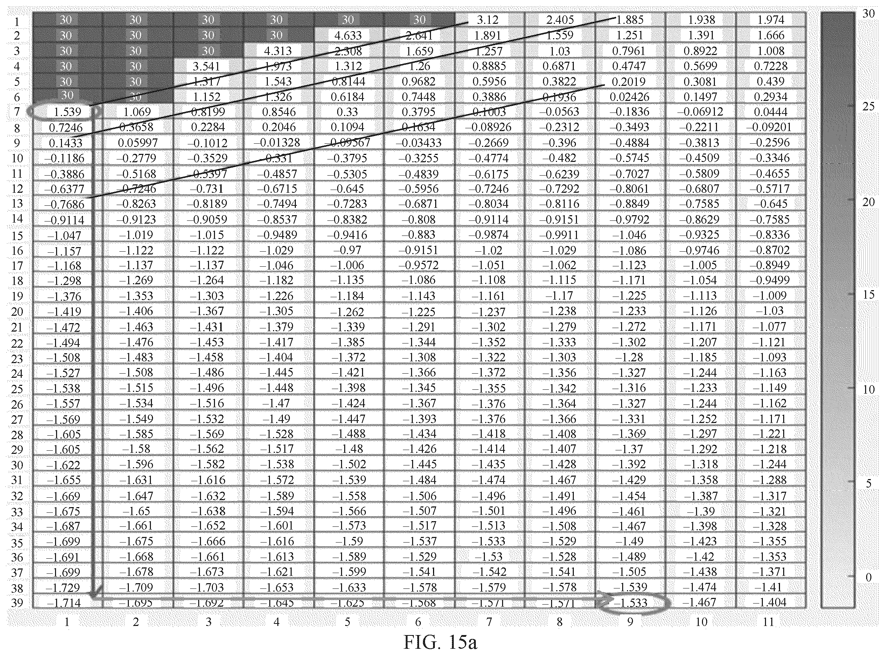

FIG. 15a is a diagram of a JSCC transmission path based on an NR BG2 when p1=0.2 according to an embodiment of this application. For descriptions of horizontal and vertical coordinates, oblique lines, and the like in FIG. 15a, refer to FIG. 8a. Details are not described herein again.

In this case, when p1=0.20, an available initial extended code rate is determined as a start point of the transmission path. For example, the initial code rate R=10/(4+6)=1.00 is used as a start. 10 represents a total quantity of information columns, 4 represents a quantity of core parity columns, and 6 represents a quantity of information columns corresponding to the K₁ information bits. A code rate R obtained through extension of all parity columns is R=10/(4+37+8)=0.2 (or a lower code rate may be obtained by repeatedly extending transmitted columns). 10 represents a total quantity of information columns, 4 represents a quantity of core parity columns, 37 represents a quantity of extension parity columns corresponding to the N₁ parity bits, and 8 represents a quantity of information columns corresponding to the K₁ information bits.

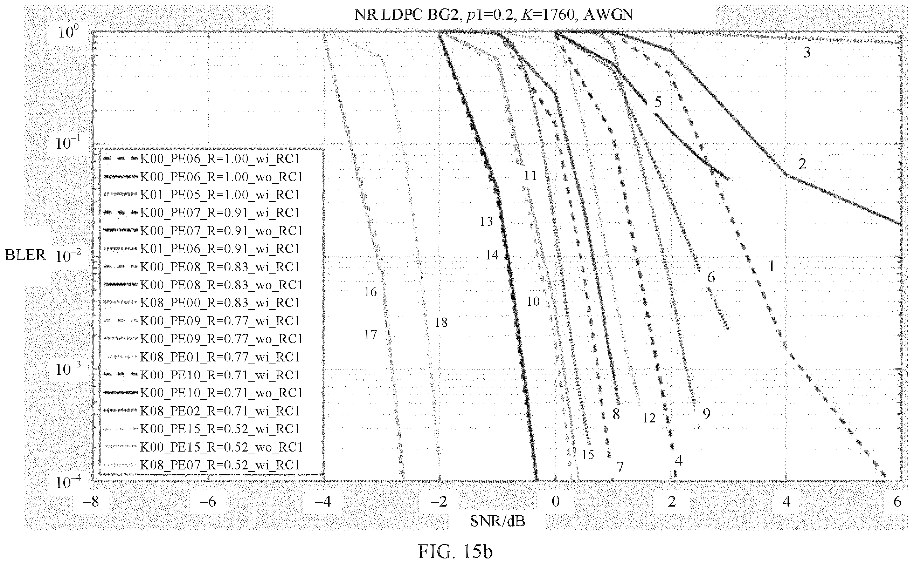

FIG. 15b is a diagram of simulation results according to an embodiment of this application. For descriptions of horizontal and vertical coordinates in FIG. 15b, refer to FIG. 8b. Details are not described herein again. In the simulation graph shown in FIG. 15b, information bits are 1760 bits. These information bits are generated according to Bernoulli distribution based on p1=0.10. In this case, an extended transmission scheme in which the RC-1 is included has better performance at various code rates. In addition, the transmission path provided in this embodiment of this application achieves desirable BLER performance, and there is a loss in performance of other tested paths deviated from the optimal path.

### Implementation 8:

For similar content, refer to the implementation 5 to the implementation 7. In this embodiment of this application, when source sparsity p1=0.30, for a transmission scheme in which the RC-1 is included or removed, an optimal decoding threshold cannot be reached by transmitting only parity bits, and a specific quantity of information bits need to be transmitted to reach a desirable decoding threshold.

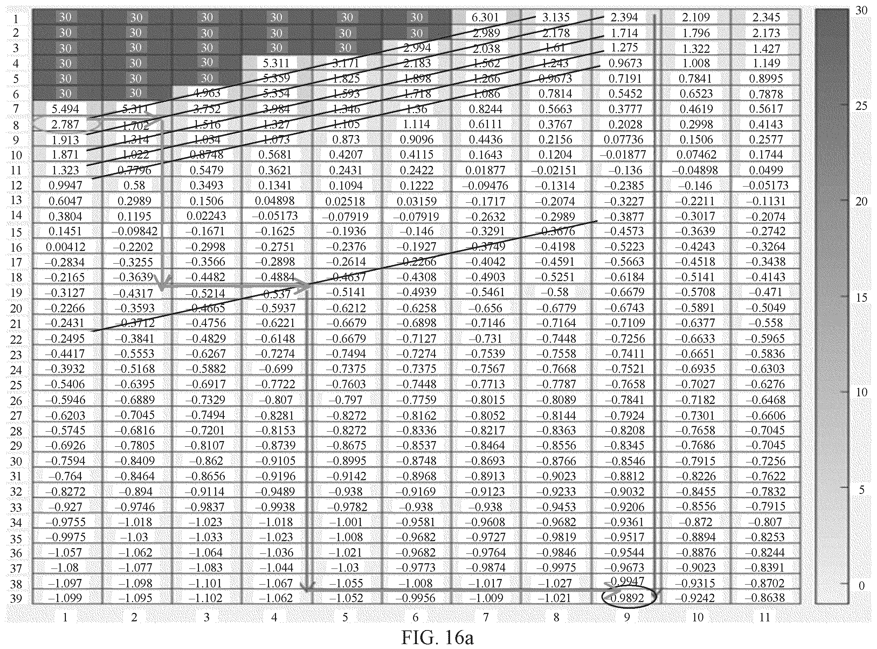

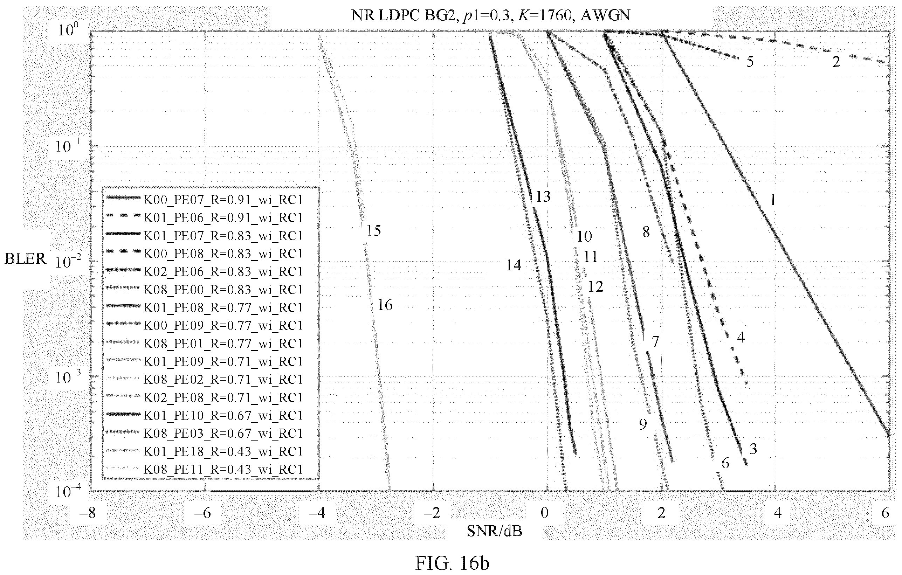

FIG. 16a shows two paths, where a path corresponding to a vertical line on the right can be understood as a CC mode. It can be learned from FIG. 16a that decoding thresholds corresponding to the two paths change sharply when a source is not particularly sparse, and the decoding thresholds of the two paths at a same code rate slightly differ from each other. FIG. 16b is a diagram of simulation results according to an embodiment of this application. Information bits are 1760 bits. These information bits are generated according to Bernoulli distribution based on p1=0.30. For a case in which p1=0.3, it can be learned that there is a slight performance difference between a conventional channel coding mode and the transmission path provided in this embodiment of this application. In this case, when p1>0.2, a transmission mode may fall back to a channel coding mode.

It can be understood that in the foregoing embodiments or implementations, for content that is not detailed in one embodiment or implementation, refer to other embodiments or implementations.

The following describes communication apparatuses provided in embodiments of this application.

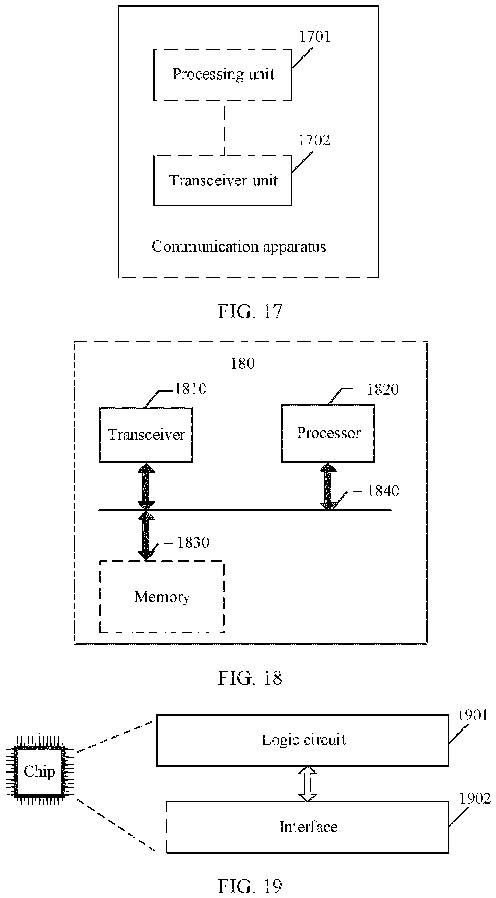

In this application, functional modules of the communication apparatuses are obtained through division based on the foregoing method embodiment. For example, functional modules may be obtained through division in correspondence to functions, or two or more functions may be integrated into one processing module. The integrated module may be implemented in a form of hardware, or may be implemented in a form of a software functional module. It should be noted that division into modules in this application is an example, is merely logical function division, and may be other division during actual implementation. The following details the communication apparatuses in embodiments of this application with reference to FIG. 17 to FIG. 19.

FIG. 17 is a diagram of a structure of a communication apparatus according to an embodiment of this application. As shown in FIG. 17, the communication apparatus includes a processing unit 1701 and a transceiver unit 1702.

In some embodiments of this application, the communication apparatus may be the transmit end or the chip shown above, and the chip may be disposed in the transmit end. In other words, the communication apparatus may be configured to perform the steps, the functions, or the like performed by the transmit end in the foregoing method embodiment.

The processing unit 1701 is configured to obtain a first bit sequence.

The processing unit 1701 is further configured to perform low-density parity-check LDPC encoding based on the first bit sequence to obtain a second bit sequence.

The processing unit 1701 is configured to output the second bit sequence by using the transceiver unit 1702.

It can be understood that, that the processing unit outputs the second bit sequence by using the transceiver unit herein can be understood as follows: The processing unit may send the second bit sequence to another component by using the transceiver unit, or sends a modulation symbol of the second bit sequence to a receive end by using the transceiver unit. Details are not enumerated in this embodiment of this application.

In a possible implementation, the processing unit 1701 is specifically configured to: if first sparsity is less than or equal to a first threshold, perform LDPC encoding based on the first bit sequence to obtain the second bit sequence.

In a possible implementation, the processing unit 1701 is specifically configured to: perform LDPC encoding based on the first bit sequence to obtain a third bit sequence; and perform, based on the first sparsity, at least one of the following: determine N₁ parity bits from N₀ parity bits, and determine K₁ information bits from K₀ information bits.

In a possible implementation, the transceiver unit 1702 is configured to send indication information.

Still with reference to FIG. 17, in some other embodiments of this application, the communication apparatus may be the receive end or the chip shown above, and the chip may be disposed in the receive end. In other words, the communication apparatus may be configured to perform the steps, the functions, or the like performed by the receive end in the foregoing method embodiment.

The processing unit 1701 is configured to determine, based on first sparsity and a code rate, that the second bit sequence includes K₁ information bits and N₁ parity bits.

The processing unit 1701 is further configured to perform low-density parity-check LDPC decoding on the second bit sequence based on the first sparsity and the code rate, to obtain K₀ information bits.

It can be understood that the transceiver unit 1702 may be configured to input a signal like a modulation symbol transmitted through a channel, and then the processing unit may process the signal to obtain the second bit sequence.

In a possible implementation, the transceiver unit 1702 is configured to receive indication information.

It can be understood that specific descriptions of the transceiver unit and the processing unit described in this embodiment of this application are merely examples. For specific functions, execution steps, or the like of the transceiver unit and the processing unit, refer to the foregoing method embodiment. Details are not described herein again.

The foregoing describes the communication apparatus in this embodiment of this application. The following describes a possible product form of the communication apparatus. It should be understood that a product in any form that has functions of the communication apparatus in FIG. 17 falls within the protection scope of embodiments of this application.

In a possible implementation, in the communication apparatus shown in FIG. 17, the processing unit 1701 may be one or more processors; and the transceiver unit 1702 may be a transceiver, or the transceiver unit 1702 may be a sending unit and a receiving unit, the sending unit may be a transmitter, and the receiving unit may be a receiver. The sending unit and the receiving unit are integrated into one device, for example, a transceiver. In this embodiment of this application, the processor and the transceiver may be coupled or the like, and a connection mode between the processor and the transceiver is not limited in embodiments of this application. In a process of performing the foregoing method, a process of sending information in the foregoing method can be understood as a process of outputting the information by the processor. When outputting the information, the processor outputs the information to the transceiver, so that the transceiver transmits the information. After the information is output by the processor, other processing may further need to be performed on the information, and then processed information arrives at the transceiver. Similarly, a process of receiving information in the foregoing method can be understood as a process of receiving the input information by the processor. When the processor receives the input information, the transceiver receives the information, and inputs the information into the processor. Further, after the transceiver receives the information, other processing may need to be performed on the information, and then processed information is input into the processor.

As shown in FIG. 18, a communication apparatus 180 includes one or more processors 1820 and a transceiver 1810.

For example, when the communication apparatus is configured to perform the steps, the methods, or the functions performed by the transmit end, the processor 1820 is configured to obtain a first bit sequence; the processor 1820 is further configured to perform low-density parity-check LDPC encoding based on the first bit sequence to obtain a second bit sequence; and the processor 1820 is configured to send the second bit sequence by using the transceiver 1810. For example, the transceiver 1810 may send a signal obtained through rate matching, modulation, or the like performed on the second bit sequence.

In a possible implementation, the processor 1820 is specifically configured to: if first sparsity is less than or equal to a first threshold, perform LDPC encoding based on the first bit sequence to obtain the second bit sequence.

In a possible implementation, the processor 1820 is specifically configured to: perform LDPC encoding based on the first bit sequence to obtain a third bit sequence; and perform, based on the first sparsity, at least one of the following: determine N₁ parity bits from N₀ parity bits, and determine K₁ information bits from K₀ information bits.

In a possible implementation, the transceiver 1810 is configured to send indication information.

For example, when the communication apparatus is configured to perform the steps, the methods, or the functions performed by the receive end, the processor 1820 is configured to determine, based on first sparsity and a code rate, that the second bit sequence includes K₁ information bits and N₁ parity bits; and the processor 1820 is further configured to perform low-density parity-check LDPC decoding on the second bit sequence based on the first sparsity and the code rate, to obtain K₀ information bits.

It can be understood that the transceiver 1810 may be configured to receive a signal like a modulation symbol transmitted through a channel, and then the processor may process the signal to obtain the second bit sequence.

In a possible implementation, the transceiver 1810 is configured to receive indication information.

It can be understood that for specific descriptions of the processor and the transceiver, refer to the descriptions of the processing unit and the transceiver unit shown in FIG. 17. Details are not described herein again.

In various implementations of the communication apparatus shown in FIG. 18, the transceiver may include a receiver and a transmitter, the receiver is configured to perform a receiving function (or operation), and the transmitter is configured to perform a sending function (or operation). In addition, the transceiver is configured to communicate with another device/apparatus through a transmission medium.

Optionally, the communication apparatus 180 may further include one or more memories 1830, configured to store program instructions, data, and/or the like. The memory 1830 is coupled to the processor 1820. The coupling in this embodiment of this application may be an indirect coupling or a communication connection between apparatuses, units, or modules in an electrical form, a mechanical from, or another form, and is used for information exchange between the apparatuses, the units, or the modules. The processor 1820 may perform an operation with the memory 1830 cooperatively. The processor 1820 may execute the program instructions stored in the memory 1830. Optionally, at least one of the one or more memories may be included in the processor. Optionally, the one or more memories may be configured to store the transmission path in embodiments of this application.

A specific connection medium between the transceiver 1810, the processor 1820, and the memory 1830 is not limited in embodiment of this application. In this embodiment of this application, the memory 1830, the processor 1820, and the transceiver 1810 are connected through a bus 1840 in FIG. 18. The bus is represented by a bold line in FIG. 18. This is only an example for description and does not constitute any limitation. There may be other connection modes between the components. The bus may be classified into an address bus, a data bus, a control bus, and the like. For ease of representation, the bus is represented by using only one bold line in FIG. 18, but this does not mean that there is only one bus or one type of bus.

In this embodiment of this application, the processor may be a general-purpose processor, a digital signal processor, an application-specific integrated circuit, a field programmable gate array, another programmable logic device, a discrete gate, a transistor logic device, a discrete hardware component, or the like, and can implement or execute the methods, steps, and logical block diagrams disclosed in embodiments of this application. The general-purpose processor may be a microprocessor, any conventional processor, or the like. The steps of the methods disclosed with reference to embodiments of this application may be directly implemented by a hardware processor, or may be implemented by a combination of hardware in the processor and a software module, or the like.

In this embodiment of this application, the memory may include but is not limited to a non-volatile memory like a hard disk drive (hard disk drive, HDD) or a solid-state drive (solid-state drive, SSD), a random access memory (Random Access Memory, RAM), an erasable programmable read-only memory (Erasable Programmable ROM, EPROM), a read-only memory (Read-Only Memory, ROM), or a compact disc read-only memory (Compact Disc Read-Only Memory, CD-ROM). The memory may be any other medium that can be used to carry or store program code in a form of instructions or a data structure and that can be read and/or written by a computer (for example, the communication apparatus described in this application), but is not limited thereto. Alternatively, the memory in this embodiment of this application may be a circuit or any other apparatus that can implement a storage function, and is configured to store program instructions and/or data.

For example, the processor 1820 is mainly configured to: process a communication protocol and communication data, control the entire communication apparatus, execute a software program, and process data of the software program. The memory 1830 is mainly configured to store the software program and the data. The transceiver 1810 may include a control circuit and an antenna. The control circuit is mainly configured to: perform conversion between a baseband signal and a radio frequency signal, and process the radio frequency signal. The antenna is mainly configured to receive and send a radio frequency signal in a form of an electromagnetic wave. An input/output apparatus, like a touchscreen, a display, or a keyboard, is mainly configured to receive data input by a user and output data to the user.

After the communication apparatus is powered on, the processor 1820 may read the software program from the memory 1830, interpret and execute instructions of the software program, and process the data of the software program. When data needs to be sent wirelessly, the processor 1820 performs baseband processing on the to-be-sent data, and outputs a baseband signal to a radio frequency circuit. The radio frequency circuit performs radio frequency processing on the baseband signal, and then sends out a radio frequency signal in a form of an electromagnetic wave through the antenna. When data is sent to the communication apparatus, the radio frequency circuit receives a radio frequency signal through the antenna, converts the radio frequency signal into a baseband signal, and outputs the baseband signal to the processor 1820. The processor 1820 converts the baseband signal into data and processes the data.

In another implementation, the radio frequency circuit and the antenna may be disposed independently of the processor that performs baseband processing. For example, in a distributed scenario, the radio frequency circuit and the antenna may be remotely disposed independent of the communication apparatus.

It can be understood that the communication apparatus described in this embodiment of this application may alternatively include more components than those in FIG. 18, or the like. This is not limited in embodiments of this application. The foregoing methods performed by the processor and the transceiver are merely an example. For specific steps performed by the processor and the transceiver, refer to the methods described above.

In another possible implementation, in the communication apparatus shown in FIG. 17, the processing unit 1701 may be one or more logic circuits, and the transceiver unit 1702 may be an input/output interface, or may be referred to as a communication interface, an interface circuit, an interface, or the like. Alternatively, the transceiver unit 1702 may include a sending unit and a receiving unit. The sending unit may be an output interface, and the receiving unit may be an input interface. The sending unit and the receiving unit are integrated into one unit, for example, an input/output interface. As shown in FIG. 19, the communication apparatus shown in FIG. 19 includes a logic circuit 1901 and an interface 1902. In other words, the processing unit 1701 may be implemented by using the logic circuit 1901, and the transceiver unit 1702 may be implemented by using the interface 1902. The logic circuit 1901 may be a chip, a processing circuit, an integrated circuit, a system on chip (system on chip, SoC), or the like. The interface 1902 may be a communication interface, an input/output interface, a pin, or the like. For example, in FIG. 19, the communication apparatus is a chip, and the chip includes a logic circuit 1901 and an interface 1902.

In this embodiment of this application, the logic circuit and the interface may be further coupled to each other. A specific connection mode between the logic circuit and the interface is not limited in embodiments of this application.

For example, when the communication apparatus is configured to perform the methods, the functions, or the steps performed by the transmit end, the logic circuit 1901 is configured to obtain a first bit sequence; the logic circuit 1901 is further configured to perform low-density parity-check LDPC encoding based on the first bit sequence to obtain a second bit sequence; and the interface 1902 is configured to output the second bit sequence.

It can be understood that the interface may output the second bit sequence, so that another component in the transmit end processes the second bit sequence. Alternatively, the interface is configured to output a symbol sequence obtained by performing rate matching, modulation, frequency conversion, and other operations on the second bit sequence.

In a possible implementation, the logic circuit 1901 is specifically configured to: if first sparsity is less than or equal to a first threshold, perform LDPC encoding based on the first bit sequence to obtain the second bit sequence.

In a possible implementation, the logic circuit 1901 is specifically configured to: perform LDPC encoding based on the first bit sequence to obtain a third bit sequence; and perform, based on the first sparsity, at least one of the following: determine N₁ parity bits from N₀ parity bits, and determine K₁ information bits from K₀ information bits.

In a possible implementation, the interface 1902 is configured to output indication information.

For example, when the communication apparatus is configured to perform the methods, the functions, or the steps performed by the receive end, the logic circuit 1901 is configured to determine that the second bit sequence includes K₁ information bits and N₁ parity bits; and the logic circuit 1901 is further configured to perform low-density parity-check LDPC decoding on the second bit sequence based on first sparsity and a code rate, to obtain K₀ information bits.

It can be understood that the interface 1902 may be configured to input a signal like a modulation symbol transmitted through a channel, and then a logic circuit may process the signal to obtain the second bit sequence. Certainly, the logic circuit that processes the signal may be the same as or different from the logic circuit that performs the LDPC decoding. This is not limited in embodiments of this application.

In a possible implementation, the interface 1902 is configured to input indication information.

For the embodiments shown in FIG. 17 to FIG. 19, in a possible implementation, the N₁ parity bits are determined based on A parity columns in a base graph BG1, or the N₁ parity bits are determined based on B parity columns in a base graph BG2, both A and B are positive integers, A is less than 46, and B is less than 41.

In a possible implementation, the A parity columns are determined in order from left to right by using core parity columns in the BG1 as a start point, or the B parity columns are determined in order from left to right by using core parity columns in the BG2 as a start point.

In a possible implementation, when the first sparsity is less than or equal to a second threshold, the A parity columns do not include a 1^{st} column of extension parity columns in the BG1.

In a possible implementation, when the first sparsity is greater than a second threshold, the A parity columns include a 1^{st} column of extension parity columns in the BG1, or the B parity columns include a 1^{st} column of extension parity columns in the BG2.

In a possible implementation, A is greater than or equal to 8.

In a possible implementation, B is greater than or equal to 5.

In a possible implementation, the K₁ information bits are determined based on C information columns in the base graph BG1, or the K₁ information bits are determined based on D information columns in the base graph BG2, and both C and D are nonnegative integers.

In a possible implementation, the C information columns are determined in order from right to left by using the core parity columns in the BG1 as a start point, or the D information columns are determined in order from right to left by using the core parity columns in the BG2 as a start point.

In a possible implementation, C is less than or equal to 20, or D is less than or equal to 8.

In a possible implementation, when the first sparsity is less than or equal to a third threshold, C is equal to 0, or D is equal to 0.

In a possible implementation, when the first sparsity is greater than a third threshold, C is greater than or equal to 5.

In a possible implementation, when the first sparsity is less than or equal to a fourth threshold, an initial code rate of the LDPC encoding is greater than 1.

Certainly, the foregoing implementations are merely examples. For specific descriptions, refer to the foregoing method embodiment. Details are not described herein again.

It can be understood that the communication apparatuses described in embodiments of this application may implement the methods provided in embodiments of this application in a form of hardware, or may implement the methods provided in embodiments of this application in a form of software. This is not limited in embodiments of this application.

For specific implementations of the embodiment shown in FIG. 19, refer to the foregoing embodiments. Details are not described herein again.

An embodiment of this application further provides a wireless communication system. The wireless communication system includes a transmit end and a receive end. The transmit end and the receive end may be configured to perform the methods in any one of the foregoing embodiments. Alternatively, for the transmit end and the receive end, refer to the communication apparatuses shown in FIG. 17 to FIG. 19.

In addition, this application further provides a computer program. The computer program is used to implement operations and/or processing performed by the transmit end in the methods provided in this application.

This application further provides a computer program. The computer program is used to implement operations and/or processing performed by the receive end in the methods provided in this application.

This application further provides a computer-readable storage medium. The computer-readable storage medium stores computer code. When the computer code is run on a computer, the computer is enabled to perform operations and/or processing performed by the transmit end in the methods provided in this application.

This application further provides a computer-readable storage medium. The computer-readable storage medium stores computer code. When the computer code is run on a computer, the computer is enabled to perform operations and/or processing performed by the receive end in the methods provided in this application.

This application further provides a computer program product. The computer program product includes computer code or a computer program. When the computer code or the computer program is run on a computer, operations and/or processing performed by the transmit end in the methods provided in this application are/is performed.

This application further provides a computer program product. The computer program product includes computer code or a computer program. When the computer code or the computer program is run on a computer, operations and/or processing performed by the receive end in the methods provided in this application are/is performed.

In the several embodiments provided in this application, it should be understood that the disclosed systems, apparatuses, and methods may be implemented in other manners. For example, the described apparatus embodiments are merely examples. For example, division into units is merely logical function division and may be other division during actual implementation. For example, a plurality of units or components may be combined or may be integrated into another system, or some features may be ignored or not be performed. In addition, the displayed or discussed mutual couplings or direct couplings or communication connections may be implemented through some interfaces. The indirect couplings or communication connections between the apparatuses or units may be implemented in an electrical form, a mechanical from, or another form.

The units described as separate parts may or may not be physically separate, and parts displayed as units may or may not be physical units. To be specific, the parts may be located in one position or may be distributed on a plurality of network units. Some or all of the units may be selected depending on an actual requirement to achieve technical effects of the solutions provided in embodiments of this application.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in a form of a software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in a form of a software product. The computer software product is stored in a readable storage medium and includes several instructions for instructing a computer device (which may be a personal computer, a server, a network device, or the like) to perform all or some of the steps of the methods described in embodiments of this application. The readable storage medium includes any medium that can store program code, like a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An encoding method, wherein the method comprises:
obtaining a first bit sequence, wherein sparsity of the first bit sequence is first sparsity, the first sparsity is used to indicate a proportion of 1 or 0 in the first bit sequence, the first bit sequence comprises K₀ information bits, and K₀ is a positive integer;
performing low-density parity-check LDPC encoding based on the first bit sequence to obtain a second bit sequence, wherein the second bit sequence comprises K₁ information bits and N₁ parity bits, a value of K₁ is determined based on the first sparsity, K₁ is less than K₀, K₁ is a nonnegative integer, and N₁ is a positive integer; and
sending the second bit sequence.

2. The method according to claim 1, wherein the performing low-density parity-check LDPC encoding based on the first bit sequence to obtain a second bit sequence comprises:
if the first sparsity is less than or equal to a first threshold, performing LDPC encoding based on the first bit sequence to obtain the second bit sequence.

3. The method according to claim 2, wherein the performing LDPC encoding based on the first bit sequence to obtain the second bit sequence comprises:
performing LDPC encoding based on the first bit sequence to obtain a third bit sequence, wherein the third bit sequence comprises K₀ information bits and N₀ parity bits, and N₀ is an integer greater than or equal to N₁; and
performing, based on the first sparsity, at least one of the following: determining the N₁ parity bits from the N₀ parity bits, and determining the K₁ information bits from the K₀ information bits.

4. The method according to claim 3, wherein the N₁ parity bits are determined based on A parity columns in a base graph BG1, or the N₁ parity bits are determined based on B parity columns in a base graph BG2, both A and B are positive integers, A is less than 46, and B is less than 41.

5. The method according to claim 4, wherein the A parity columns are determined in order from left to right by using core parity columns in the BG1 as a start point, or the B parity columns are determined in order from left to right by using core parity columns in the BG2 as a start point.

6. The method according to claim 5, wherein when the first sparsity is less than or equal to a second threshold, the A parity columns do not comprise a 1^{st} column of extension parity columns in the BG1, and the B parity columns comprise a 1^{st} column of extension parity columns in the BG2.

7. The method according to claim 5, wherein when the first sparsity is greater than a second threshold, the A parity columns comprise a 1^{st} column of extension parity columns in the BG1, or the B parity columns comprise a 1^{st} column of extension parity columns in the BG2.

8. The method according to any one of claims 4 to 7, wherein A is greater than or equal to 8.

9. The method according to any one of claims 4 to 7, wherein B is greater than or equal to 5.

10. The method according to any one of claims 3 to 9, wherein the K₁ information bits are determined based on C information columns in the base graph BG1, or the K₁ information bits are determined based on D information columns in the base graph BG2, and both C and D are nonnegative integers.

11. The method according to claim 10, wherein the C information columns are determined in order from right to left by using the core parity columns in the BG1 as a start point, or the D information columns are determined in order from right to left by using the core parity columns in the BG2 as a start point.

12. The method according to claim 10 or 11, wherein C is less than or equal to 20, or D is less than or equal to 8.

13. The method according to any one of claims 10 to 12, wherein when the first sparsity is less than or equal to a third threshold, C is equal to 0, or D is equal to 0.

14. The method according to claim 13, wherein when the first sparsity is greater than the third threshold, C is greater than or equal to 5.

15. The method according to any one of claims 1 to 14, wherein when the first sparsity is less than or equal to a fourth threshold, an initial code rate of the LDPC encoding is greater than or equal to 1.

16. The method according to any one of claims 1 to 15, wherein the method further comprises:
sending indication information, wherein the indication information indicates the first sparsity.

17. A decoding method, wherein the method comprises:
obtaining a second bit sequence;
determining, based on first sparsity and a code rate, that the second bit sequence comprises K₁ information bits and N₁ parity bits, wherein K₁ is a nonnegative integer, and N₁ is a positive integer; and
performing low-density parity-check LDPC decoding on the second bit sequence based on the first sparsity and the code rate, to obtain K₀ information bits, wherein K₀ is greater than K₁, and the first sparsity is used to indicate a proportion of 1 or 0 in the K₀ information bits.

18. The method according to claim 17, wherein the N₁ parity bits are determined based on A parity columns in a base graph BG1, or the N₁ parity bits are determined based on B parity columns in a base graph BG2, both A and B are positive integers, A is less than 46, and B is less than 41.

19. The method according to claim 18, wherein the A parity columns are determined in order from left to right by using core parity columns in the BG1 as a start point, or the B parity columns are determined in order from left to right by using core parity columns in the BG2 as a start point.

20. The method according to any one of claims 17 to 19, wherein the K₁ information bits are determined based on C information columns in the base graph BG1, or the K₁ information bits are determined based on D information columns in the base graph BG2, and both C and D are nonnegative integers.

21. The method according to claim 20, wherein the C information columns are determined in order from right to left by using the core parity columns in the BG1 as a start point, or the D information columns are determined in order from right to left by using the core parity columns in the BG2 as a start point.

22. The method according to any one of claims 17 to 21, wherein the method further comprises:
receiving indication information, wherein the indication information indicates the first sparsity.

23. A communication apparatus, wherein the apparatus comprises:
a processing unit, configured to obtain a first bit sequence, wherein sparsity of the first bit sequence is first sparsity, the first sparsity is used to indicate a proportion of 1 or 0 in the first bit sequence, the first bit sequence comprises K₀ information bits, and K₀ is a positive integer; wherein
the processing unit is further configured to perform low-density parity-check LDPC encoding based on the first bit sequence to obtain a second bit sequence, wherein the second bit sequence comprises K₁ information bits and N₁ parity bits, a value of K₁ is determined based on the first sparsity, K₁ is less than K₀, K₁ is a nonnegative integer, and N₁ is a positive integer; and
the processing unit is configured to output the second bit sequence by using a transceiver unit.

24. The apparatus according to claim 23, wherein the processing unit is specifically configured to: if the first sparsity is less than or equal to a first threshold, perform LDPC encoding based on the first bit sequence to obtain the second bit sequence.

25. The apparatus according to claim 24, wherein the processing unit is specifically configured to: perform LDPC encoding based on the first bit sequence to obtain a third bit sequence, wherein the third bit sequence comprises K₀ information bits and N₀ parity bits, and N₀ is an integer greater than or equal to N₁; and perform, based on the first sparsity, at least one of the following: determine the N₁ parity bits from the N₀ parity bits, and determine the K₁ information bits from the K₀ information bits.

26. A communication apparatus, wherein the apparatus comprises:
a processing unit, configured to obtain a second bit sequence; wherein
the processing unit is further configured to determine, based on first sparsity and a code rate, that the second bit sequence comprises K₁ information bits and N₁ parity bits, wherein K₁ is a nonnegative integer, and N₁ is a positive integer; and
the processing unit is further configured to perform low-density parity-check LDPC decoding on the second bit sequence based on the first sparsity and the code rate, to obtain K₀ information bits, wherein K₀ is greater than K₁, and the first sparsity is used to indicate a proportion of 1 or 0 in the K₀ information bits.

27. A communication apparatus, comprising a processor and a memory, wherein
the processor is configured to store instructions; and
the processor is configured to execute the instructions, so that the method according to any one of claims 1 to 22 is performed.

28. The communication apparatus according to claim 27, wherein the communication apparatus is a chip.

29. A communication apparatus, comprising a logic circuit and an interface, wherein the logic circuit is coupled to the interface; and
the interface is configured to input to-be-processed data, the logic circuit processes the to-be-processed data by using the method according to any one of claims 1 to 22, to obtain processed data, and the interface is configured to output the processed data.

30. A computer-readable storage medium, wherein the computer-readable storage medium is configured to store instructions, and when the instructions are executed, the method according to any one of claims 1 to 22 is performed.

31. A computer program, wherein when the computer program is executed, the method according to any one of claims 1 to 22 is performed.

32. A communication system, wherein the communication system comprises a transmit end and a receive end, the transmit end is configured to perform the method according to any one of claims 1 to 16, and the receive end is configured to perform the method according to any one of claims 17 to 22.
